(19) Europäisches Patentamt
European Patent Office
Office européen des brevets

(11) Publication number: **0 065 352**
**B1**

(12) **EUROPEAN PATENT SPECIFICATION**

(45) Date of publication of patent specification: **29.01.86**

(21) Application number: **82301909.6**

(22) Date of filing: **13.04.82**

(51) Int. Cl.[4]: **G 03 C 1/71**, G 03 F 7/08, C 08 L 79/08 // G03F7/26, H01L21/312, H01L21/47

(54) **Light-sensitive polymer composition.**

(30) Priority: **13.04.81 JP 54408/81**

(43) Date of publication of application: **24.11.82 Bulletin 82/47**

(45) Publication of the grant of the patent: **29.01.86 Bulletin 86/05**

(84) Designated Contracting States: **CH DE FR GB LI NL**

(56) References cited:
**EP-A-0 020 773**
**DE-A-2 914 619**

(73) Proprietor: **Hitachi, Ltd.**
**5-1, Marunouchi 1-chome**
**Chiyoda-ku Tokyo 100 (JP)**

(73) Proprietor: **Hitachi Chemical Co., Ltd.**
**1-1, Nishi-shinjuku 2-chome Shinjuku-ku**
**Tokyo 160 (JP)**

(72) Inventor: **Kataoka, Fumio**
**Keimeiryo 502, 850, Maiokacho**
**Totsuka-ku, Yokohama (JP)**
Inventor: **Shoji, Fusaji**
**Higashitotsuka-Haitsu 104 201, Akibacho**
**Totsuka-ku Yokohama (JP)**
Inventor: **Obara, Isao**
**15-14, Imaizumidai-1-chome**
**Kamakura-shi (JP)**
Inventor: **Takemoto, Issei**
**Shimookaso 12 1385, Kamiyabecho**
**Totsuka-ku Yokohama (JP)**
Inventor: **Yokono, Hitoshi**
**8-5, Chuocho**
**Katsuta-shi (JP)**
Inventor: **Isogai, Tokio**
**3941-1, Fujisawa**
**Fujisawa-shi (JP)**
Inventor: **Kojima, Mitsumasa**
**Yamazakiryo 127 2-9, Higashicho-4-chome**
**Hitachi-shi (JP)**

**EP 0 065 352 B1**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

0 065 352

(74) Representative: **Goldin, Douglas Michael et al**
**J.A. KEMP & CO. 14, South Square Gray's Inn**
**London WC1R 5EU (GB)**

**Description**

This invention relates to a light-sensitive polymer composition which can yield a heat resistant polymer.

Heretofore, as light-sensitive polymer compositions which can yield heat resistant polymers, there are known (i) a composition comprising a polymer containing as a major component a polyamide-acid or carboxyl-substituted polyamide which is a precursor of polyimide, a compound having a carbon-carbon double bond which can be dimerized or polymerized by actinic light and an amino group or its quaternary salt thereof, and if necessary a photosensitizer, a photopolymerization initiator and a copolymerizable monomer (Japanese Patent Appln. Kokai (Laid-Open) No. 145794/79) and (ii) a composition comprising a photosensitive polyamide-acid or carboxyl-substituted polyamide wherein a photoreactive vinyl group has been introduced by the reaction of the carboxyl group of the polyamide-acid or carboxyl-substituted polyamide with a primary amine having a vinyl group in its molecule in the presence of a condensing agent, and a bisazide which is a photo cross-linking agent (Japanese Patent Appln. Kokai (Laid-Open) No. 24344/81). But the composition of the above-mentioned (i) has sensitivity of several thousands $mJ/cm^2$, which sensitivity is insufficient for practical use. As to the composition of the above-mentioned (ii), since there are some problems therein, e.g., the introduction of vinyl group into the polyamide-acid or carboxyl-substituted polyamide side chain by the condensation reaction between the primary amino group and the carboxyl group is difficult, fine patterns are not formed clearly because of easy release of the pattern exposed to light at the time of development.

It is an object of this invention to provide a light-sensitive polymer composition having high sensitivity and good resolving power overcoming disadvantages of the prior art.

This invention provides a light-sensitive composition comprising

(a) 100 parts by weight of a polyamide-acid or carboxyl-substituted polyamide,

(b) 0.1 to 100 parts by weight of a bisazide,

(c) 1 to 400 parts by weight of an amine selected from the group consisting of amines containing an unsaturated bond in each molecule, and if necessary

(d) a photosensitizer.

In the above light-sensitive composition, the bisazide (b) is a photo cross-linking agent having high reactivity and imparts high sensitivity to the polyamide-acid or carboxyl-substituted polyamide (a). The amine (c) forms an ionic bond with the carboxyl group of the polyamide-acid or carboxyl-substituted polyamide (a) and forms reactive portions to nitrenes produced from the bisazide (b).

As the polyamide-acid or carboxyl-substituted polyamide (a), there can be used conventional ones which have heat resistance enough to maintain relief patterns formed even if heated at 300 to 400°C for 1 hour.

Typical example of the polyamide-acid or carboxyl-substituted polyamide has as a major component a repeating unit of the formula:

$$-\!\!\left[ CO - \underset{\substack{|\\(COOM)_n}}{R^1} - CONH - R^2 - NH \right]\!\!- \qquad (1)$$

wherein $R^1$ is a trivalent or tetravalent organic group having at least 2 carbon atoms; $R^2$ is a divalent organic group having at least 2 carbon atoms; M is hydrogen, an alkali metal or an ammonium ion; and n is an integer of 1 or 2.

In this invention, the repeating unit of the formula (1) also includes a copolymeric repeating unit of the formula:

$$-\!\!\left[ CO-\underset{\substack{|\\(COOM)_n}}{R^1}-CONH-R^2-NH \right]_p\!\!\left[ CO-\underset{\substack{|\\(COOM)_n}}{R^{1\prime}}-CONH-R^{2\prime}-NH \right]_q\!\!- \qquad (1)'$$

wherein $R^{1\prime}$ and $R^{2\prime}$ are as defined in $R^1$ and $R^2$, respectively, but at least one of them is different from $R^1$ and $R^2$, and p and q are integers of 1 or more; and the like formulae. Hereinafter $R^1$ and $R^{1\prime}$, as well as $R^2$ and $R^{2\prime}$ are treated as $R^1$ and $R^2$, respectively, for simplicity. Poly(amic acid)s of the formula (1) may be used alone or as a mixture thereof.

More concretely, $R^1$ is an aromatic ring-containing group or a heterocyclic ring-containing group such as

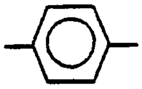 , 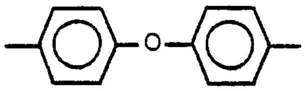 , 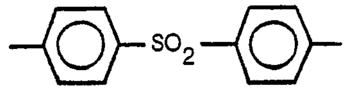 ,

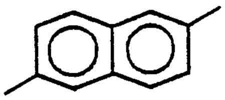 , 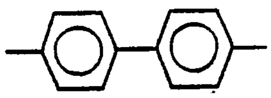 , 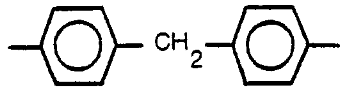 ,

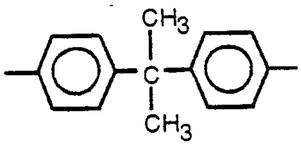 or 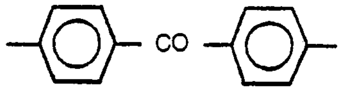 ,

wherein the two bonding lines are bonded to the two carbonyl groups of the polymer main chain and the $(COOM)_n$ group is bonded to the ortho position to either of the bonding lines. And two $R^1$ in the formula (1)' may be the same or different ones. $R^2$ is an aromatic ring-containing group, a silicon-containing group or a heterocyclic ring-containing group such as

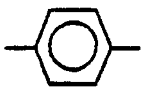 , 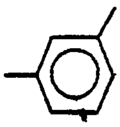 , 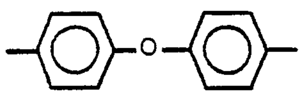 , 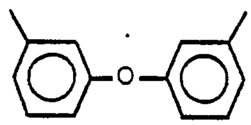 ,

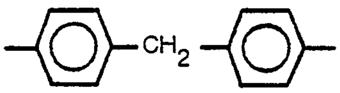 , 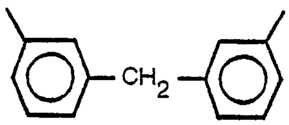 , 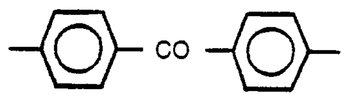 ,

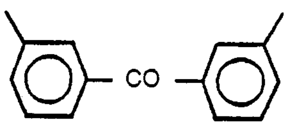 , 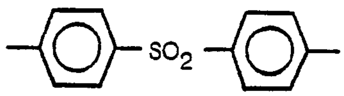 , 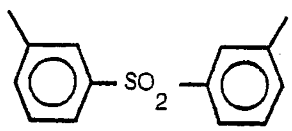 ,

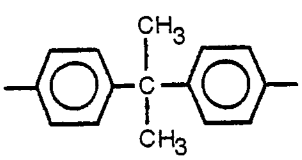 , 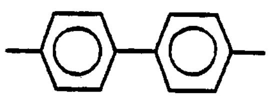 , 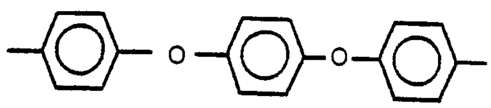 ,

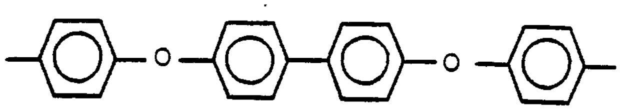 ,

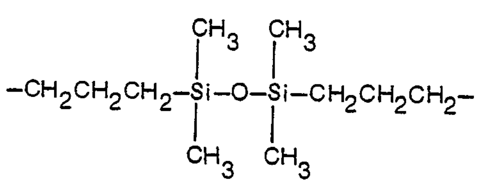 ,

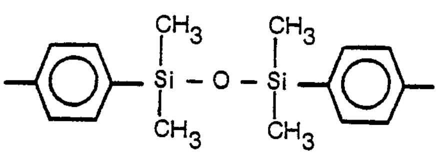 , or 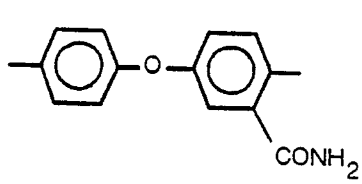 .

And two $R^2$ in the formula (1)' may be the same or different ones. $R^1$ and $R^2$ may have one or more substituents such as amino, amide, carboxyl, sulfonyl, and the like groups so far as giving no bad influence on heat resistance of the polyimide finally produced.

Preferable examples of the polyamide-acid or carboxyl-substituted polyamides of the formula (1) are that derived from pyromellitic acid dianhydride and 4,4'-diaminodiphenyl ether, that derived from pyromellitic acid dianhydride, 3,3',4,4'-benzophenone-tetracarboxylic acid dianhydride and 4,4,'-diaminodiphenyl ether, that derived from pyromellitic acid dianhydride, 3,3,',4,4'-benzophenonetetracarboxylic acid dianhydride, 4,4'-diaminodiphenyl ether and 4,4'-diaminodiphenylether-3-carbonamide, that derived from pyromellitic acid dianhydride, 3,3',4,4'-benzophenonetetracarboxylic acid dianhydride, 4,4'-diaminodiphenyl ether and bis(3-aminopropyl)tetramethyldisiloxane, etc.

More preferably examples of the polyamide-acid or carboxyl-substituted polyamides are those having as a major component the repeating unit of the formula (1), wherein $R^2$ is as defined above and $R^1$ is represented by the formula:

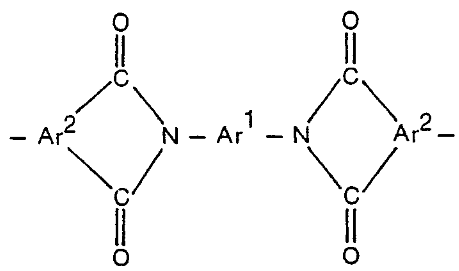 (2)

wherein $Ar^1$ is one member selected from the group consisting of

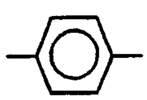 , 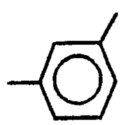 , 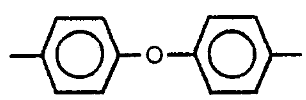 , 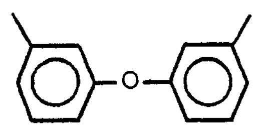 ,

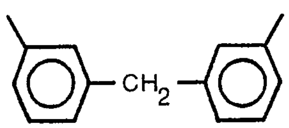 , 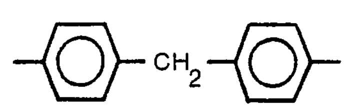 ,

and $Ar^2$ is one member selected from the group consisting of

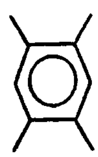 , 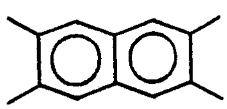 , 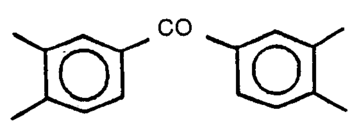 , 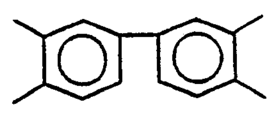 ,

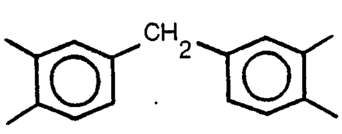 , 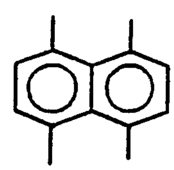 , and 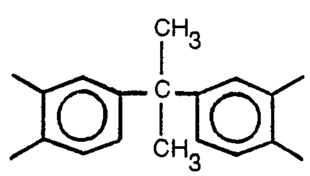 ,

wherein the three bonding lines are bonded to the three carbonyl groups of the polymer main chain and the remainder one is bonded to the COOM group. And two $Ar^2$ may be the same or different ones. The polyamide-acid or carboxyl-substituted polyamides containing as $R^2$ groups of the formula (2) can be used alone or as a mixture thereof. Such polyamide-acid or carboxyl-substituted polyamides are hardly influenced by a viscosity change and excellent in storage stability because of a lower concentration of amide-carboxylic acid in the polymer chain.

Further, there can also be used copolymerized polyamide-acid or carboxyl-substituted polyamide having a repeating unit of the formula (1) and one or more other repeating units. The kinds and amounts of copolymerizable other repeating units may be selected properly so long as giving no bad influence on heat resistance of the polyimide finally produced. Examples of copolymerizable other repeating units are those of polyesteramide acid, polyhydrazide amide acid, etc.

As the bisazide (b), there can be used one represented by the formula

$$N_3—R^3—N_3 \qquad (3)$$

wherein $R^3$ is a divalent organic group. Preferably, (3) is represented by the formulas (4) to (11) as follows:

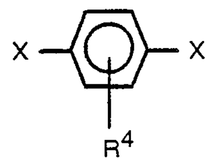

(4)

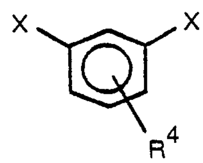

(5)

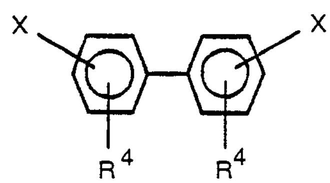

(6)

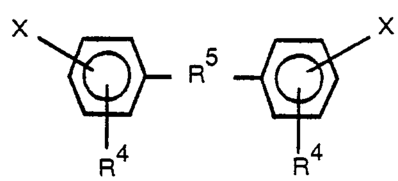

(7)

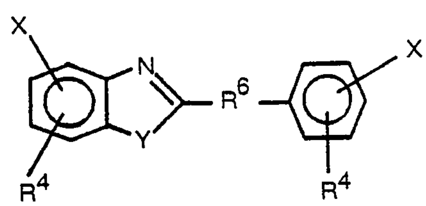

(8)

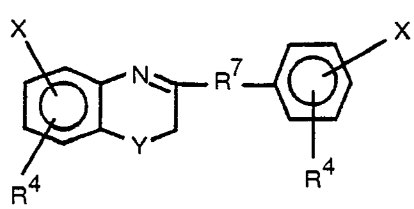

(9)

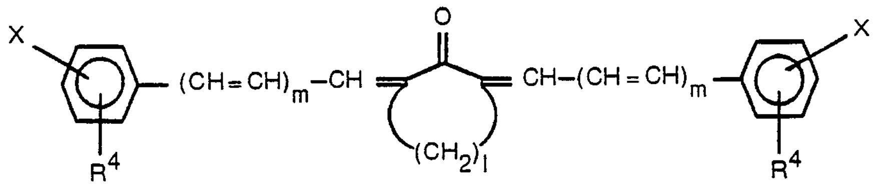

(10)

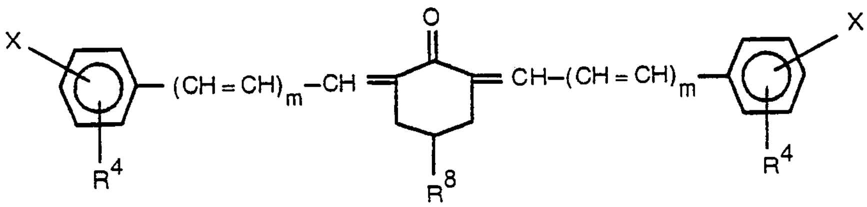

(11)

In the above formulas (4) to (11), X is $-N_3$ or $-SO_2N_3$; $R^4$ is hydrogen, an alkyl group having 1 to 6 carbon atoms, $-OH$, $-OCH_3$, $-COOH$, $-SO_3H$, $-NO_2$ or a halogen and each $R^4$ may be the same or different one; $R^5$, $R^6$, $R^7$ are independently an alkylene group

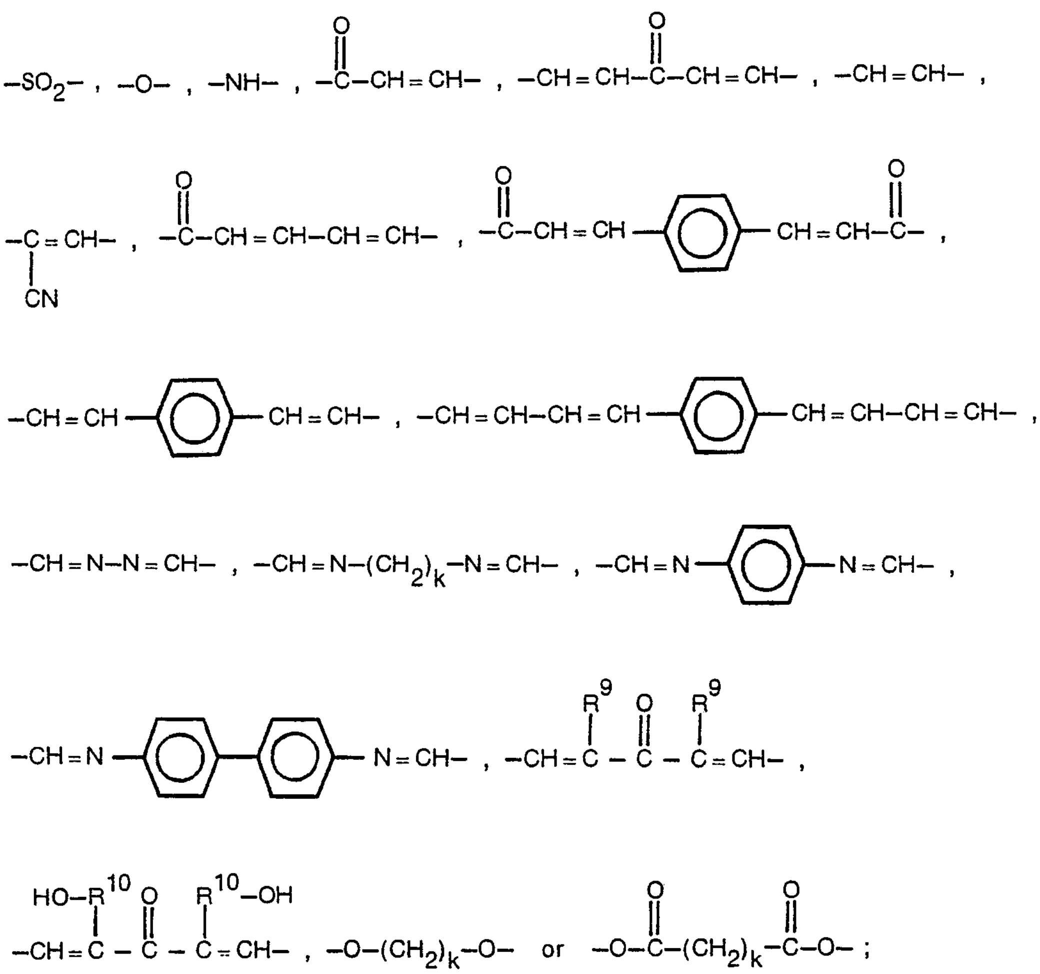

or ;

$R^8$ is $-OH$, $-OR^9$, 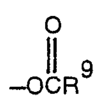, $-R^{10}-OH$, $-SiR^9_3$, $-NH_2$, $-NR^9_2$, $-COOH$, or $-COOR^9$;

$R^9$ is an alkyl group having 1 to 6 carbon atoms; $R^{10}$ is an alkylene group; Y is —O—, —S— or —NH—; l is an integer or 1 to 5; m is zero or 1.

Preferable examples of the bisazides (b) are as follows:

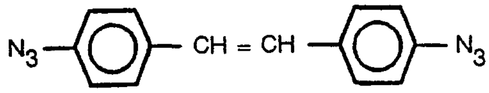 , 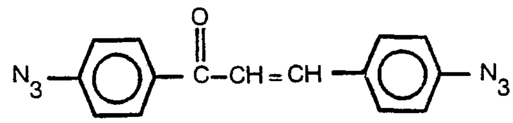 ,

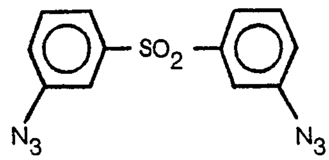 , 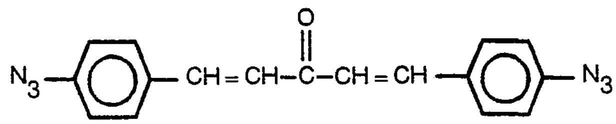 ,

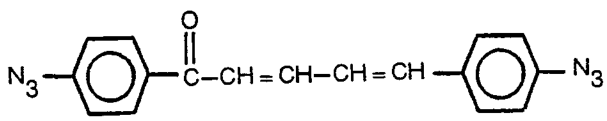 , 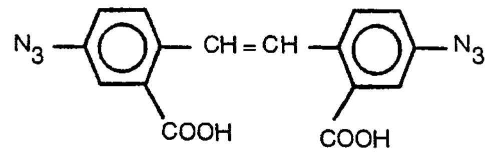 ,

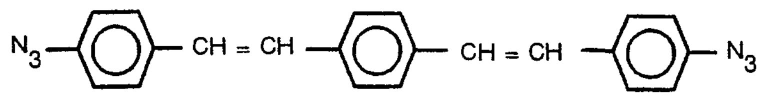 ,

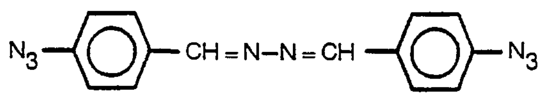 , 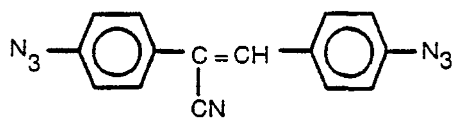 ,

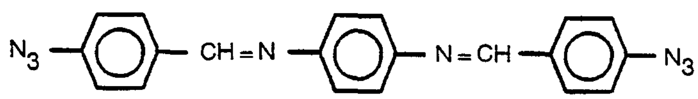 ,

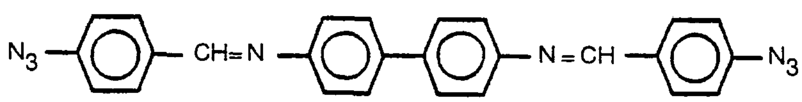 ,

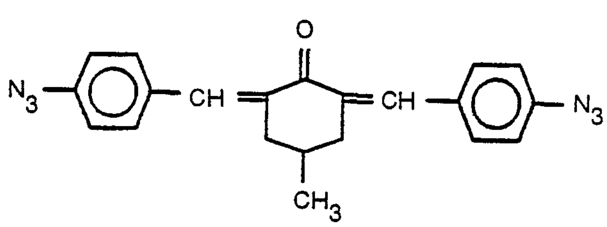 ,

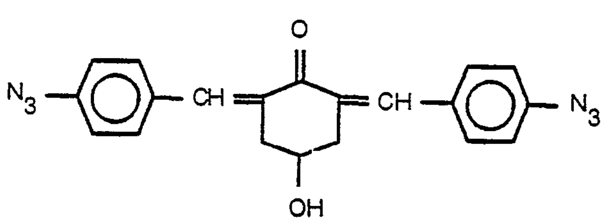

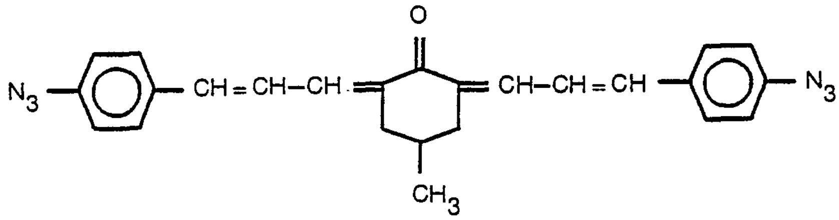,

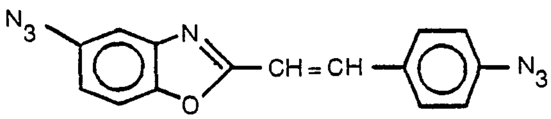,

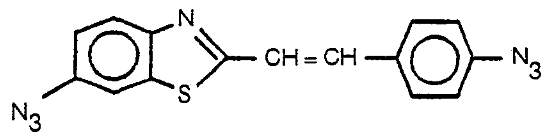,

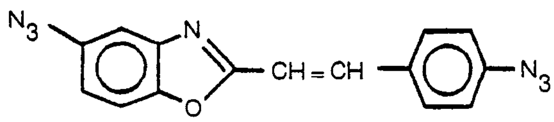,

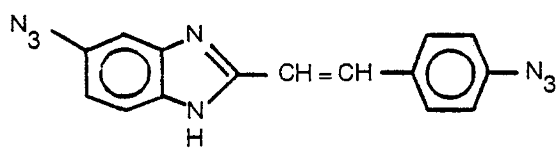,

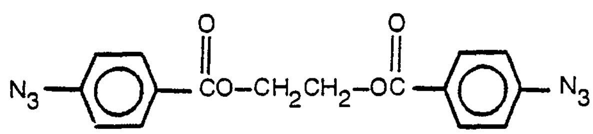,

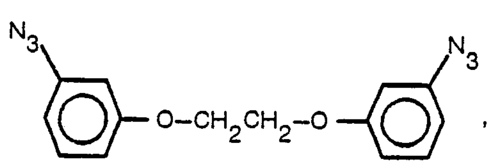, and

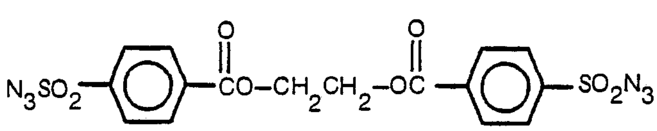.

These bisazides may be use alone or as a mixture thereof.

More preferable bisazides are those which possess higher solubilities to the aprotic polar solvents using as the solvent of the present photo sensitive polymer composition (vide infra). Examples of such bisazides are represented by the formula:

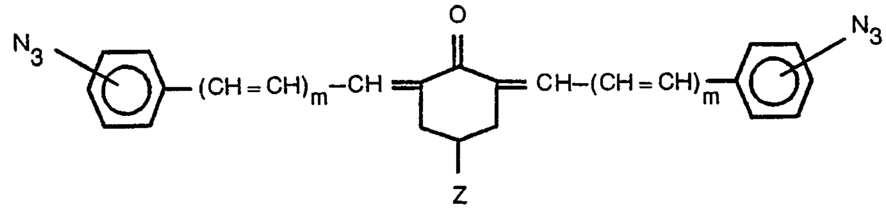

(12)

wherein Z is

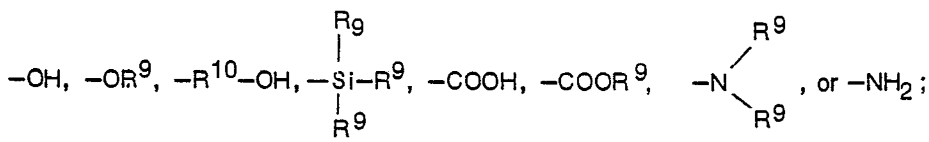

$R^9$ is an alkyl group having 1 to 6 carbon atoms; $R^{10}$ is an alkylene group; and m is zero or 1,

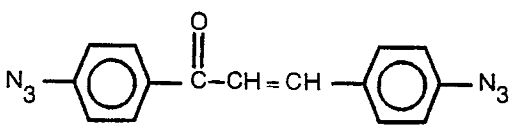

and

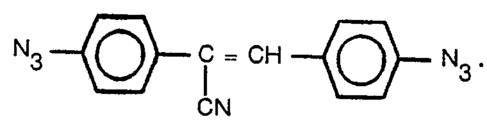

These aromatic bisazides can be used alone or as a mixture thereof.

Examples of the aromatic bisazides of the formula (12) are as follows:

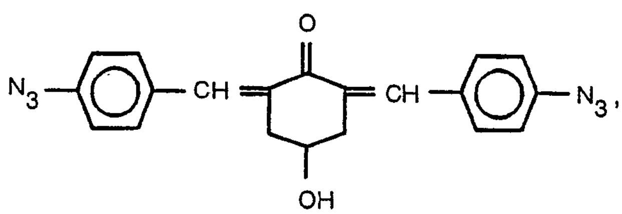

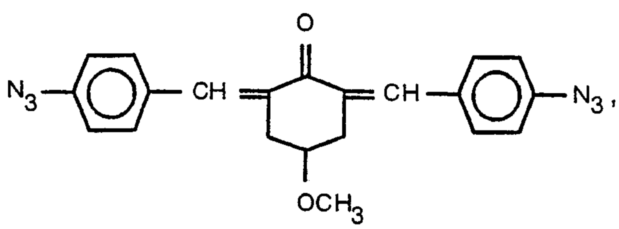

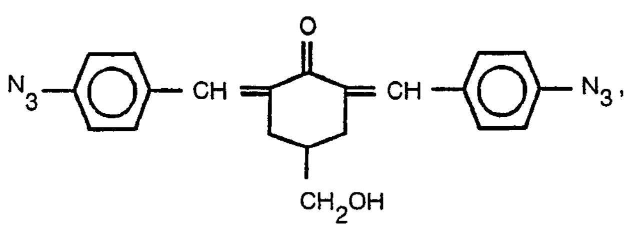

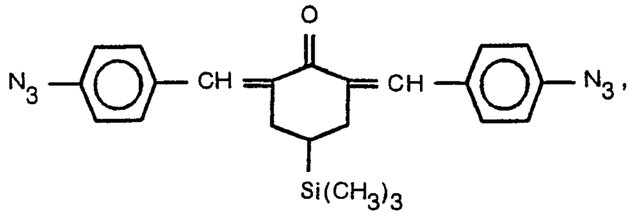

,

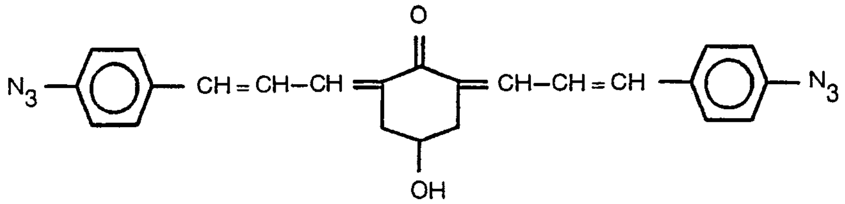

,

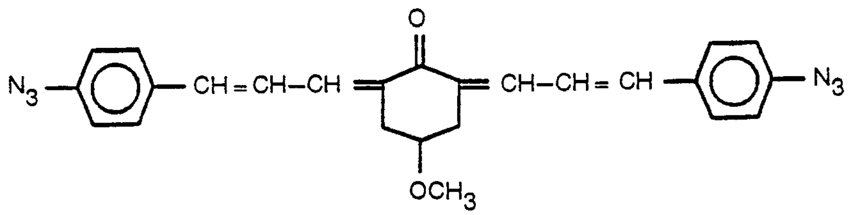

,

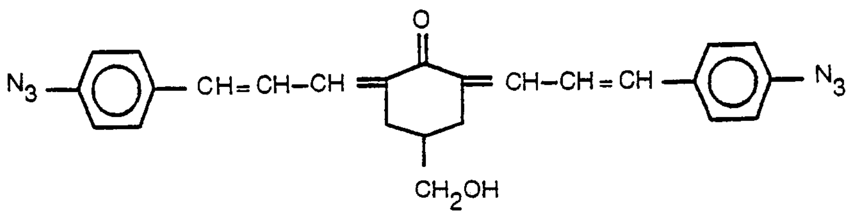

,

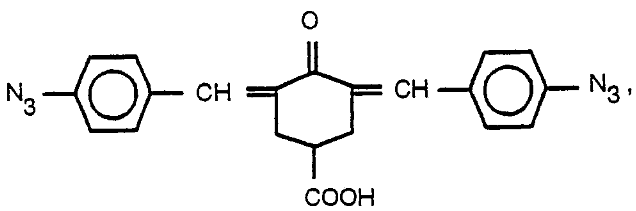

,

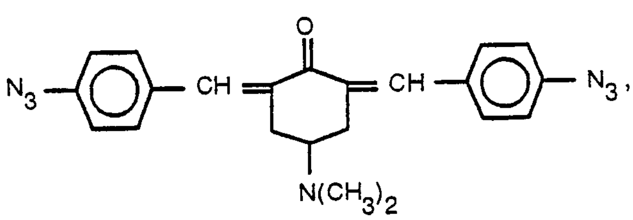

, and

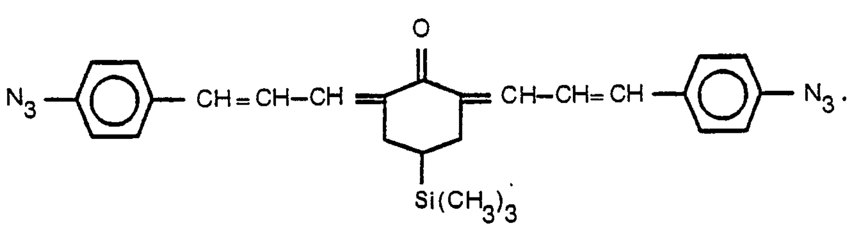

.

The polyamide-acide or carboxyl-substituted polyamide (a) and the bisazide (b) are used in amounts of 100 parts by weight of the former and 0.1 to 100 parts by weight of the latter. If the amounts are outside the above-mentioned range, portions exposed to light are easily released at the time of development or the viscosity changes greatly to make storage stability poor.

As the amine (c), there can be used those represented by the following formulas (13) to (23):

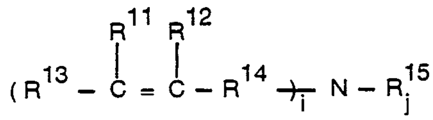

(13)

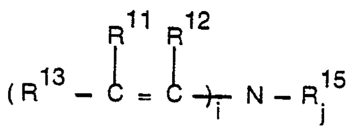

(14)

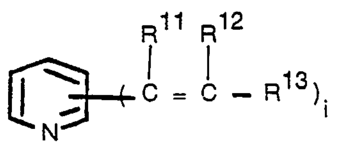

(15)

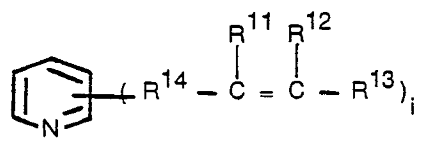

(16)

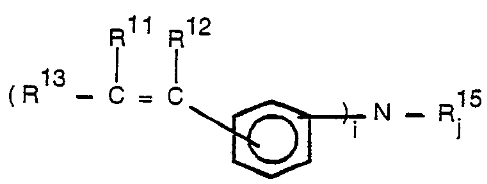

(17)

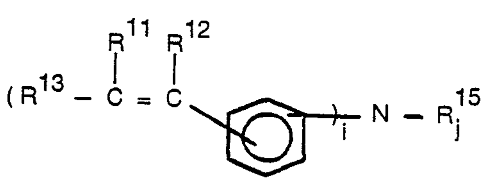

(18)

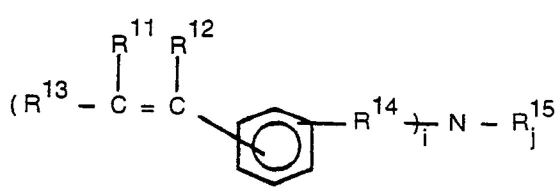

(19)

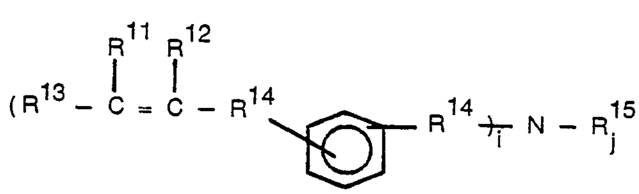

(20)

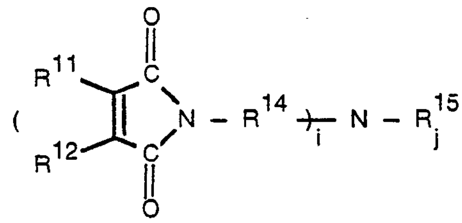 (21)

In the above formulas (13) to (23), $R^{11}$, $R^{12}$, $R^{13}$, and $R^{15}$ are independently hydrogen, an alkyl group having 1 to 6 carbon atoms, a phenyl group, or a vinyl group; $R^{14}$ is an alkylene group; i is an integer of 1 to 3, j is zero or an integer of 1 or 2 and $i+j = 3$. These amines can be used alone or as a mixture thereof.

Preferable examples of these amines are allylamine, diallylamine, triallylamine, 2-methyl-2-butenylamine, 1,3-dimethyl-1-propenylamine, 2,4-pentadienylamine, tri(2-butenyl)amine, di(2-methyl-2-propenyl)-amine, tri (2-methyl-2-propenyl)amine, 3-(N,N-dimethylamino)propyl cinnamate, N,N-dimethylallylamine, N-methyl-diallylamine, N-propyldiallylamine, 2-vinylpryridine, 4-vinylpyridine, 2-vinyl-6-methylpyridine, 2-vinyl-5-ethylpyridine, 4-butenylpyridine, 4-(1-propenylbutenyl)-pyridine, 4-pentenylpyridine, 4-(1-butenylpentenyl)-pyridine, 2-(4-pyridyl)allyl alcohol, etc.

More preferable amines are those represented by the formula:

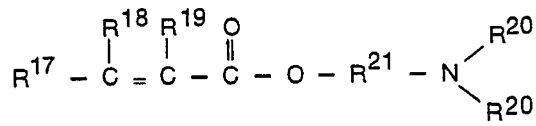 (24)

wherein $R^{17}$, $R^{18}$, and $R^{19}$, are independently hydrogen, an alkyl group preferably having 1 to 6 carbon atoms, a phenyl group, or a vinyl group; $R^{20}$ is hydrogen, a lower alkyl group preferably having 1 to 6 carbon atoms, or a vinyl group; and $R^{21}$ is an alkylene group.

Examples of the amines of the formula (24) are 2-(N,N-dimethylamino)ethyl acrylate, 2-(N,N-dimethylamino)ethyl methacrylate, 3-(N,N-dimethylamino)propyl acrylate, 3-(N,N-dimethylamino)propyl methacrylate, 4-(N,N-dimethylamino)butyl acrylate, 4-(N,N-dimethylamino)butyl methacrylate, 5-(N,N-dimethylamino)pentyl acrylate, 5-(N,N-dimethylamino)pentyl methacrylate, 6-(N,N-dimethylamino)hexyl acrylate, 6-(N,N-dimethylamino)hexyl methacrylate, 2-(N,N-dimethylamino)ethyl cinnamate, 3-(N,N-dimethylamino)propyl cinnamate, etc. These amines can be used alone or as a mixture thereof.

The amine (c) is used in an amount of 1 to 400 parts by weight based on 100 parts by weight of the polyamide-acid or carboxyl-substituted polyamide (a). When the amount of the amine (c) is outside the above-mentioned range, portions exposed to light are easily released at the time of development or film properties of the finally obtained polyimide are undesirably lowered.

The above-mentioned components (a) to (c) are used in the form of a solution dissolved in a suitable organic solvent. The use of aprotic polar solvents is preferable from the viewpoint of solubilities of these components (a) to (c). Examples of aprotic polar solvents are N-methyl-2-pyrrolidone, N-acetyl-2-pyrrolidone, N-benzyl-2-pyrrolidone, N,N-dimethylformamide, N,N-dimethylacetamide, dimethylsulfoxide, hexamethylphosphortriamide, N-acetyl-ε-caprolactam, dimethylimidazolidinone, etc. These solvents may be used alone or as a mixture thereof.

The solvent is used in an amount of preferably 100 to 10,000 parts by weight, more preferably 200 to 5,000 parts by weight based on 100 parts by weight of the total of the components (a) to (c). If the amount of the solvent is outside the above-mentioned range, film-forming properties are undesirably influenced.

The light-sensitive polymer composition of this invention comprising the polyamide-acid or carboxyl-substituted polyamide (a), the bisazide (b) and the amine (c) may further contain, if necessary, a photosensitizer (d) in order to increase the sensitivity. It is preferable to add 10 parts by weight or less of the photosensitizer based on 100 parts by weight of the total of the components (a) to (c). If the amount of the photosensitizer (d) is too much, heat resistance of polyimide finally produced is undesirably influenced.

Compounds which are effective for increasing the sensitivity of aromatic bisazides are reported in detail by Tsunoda and Yamaoka (Phot. Sci. Eng., *17,* 390 (1973)). Preferable examples of these photosensitizers are anthrone, 1,9-benzanthrone, acridine, cyanoacridine, nitropyrene, 1,8-dinitropyrene, Michler's ketone, 5-nitroacenaphthene, 2-nitrofluorenone, pyrene-1,6-quinone, 9-fluorenone, 1,2-benzanthraquinone, anthanthrone, 2-chloro-1,2-benzanthraquinone, 2-bromobenzanthraquinone, 2-chloro-1,8-phthaloylnaphthalene, etc. These photosensitizers may be used alone or as a mixture thereof.

The light-sensitive polymer composition of this invention may further contain an adhesion-improving agent.

The light-sensitive polymer composition of this invention in the form of a solution is applied to a

substrate by a spin coating method using a spinner, a dip method, a spray method, a printing method, and the like.

As the substrates, there can be used those made of metals, glass, silicon nitride, semiconductors, metal oxide insulators (e.g. $TiO_2$, $Ta_2O_5$, $SiO_2$), and the like. In order to improve the adhesion of the coating film of the light-sensitive polymer composition of this invention to the substrate, the surface of the substrate may be treated with a suitable adhesion-improving agent.

The thickness of the coating film may be controlled by a coating means, the solid content of a varnish containing the light-sensitive polymer composition of this invention, the viscosity of the varnish, and the like.

Relief patterns can be formed by a conventional method, for example, coating a varnish containing the composition of this invention on a substrate, removing the solvent by gentle heating to form a film, irradiating the varnish with ultraviolet light, and removing the portions not exposed to the light after dissolved with a developing solution. As the light source, not only ultraviolet light but also visible lights, radiation, etc. can be used.

As the developing solution, there can be used aprotic polar solvents such as N-methyl-2-pyrrolidone, N-acetyl-2-pyrrolidone, N,N-dimethylformamide, N,N-dimethylacetamide, dimethylsulfoxide, hexamethyl-phosphotriamide, dimethylimidazolidinone, N-benzyl-2-pyrrolidone, N-acetyl-ε-caprolactam and the like alone or a mixture of said aprotic polar solvent and a non-solvent for the polyamide-acid or carboxyl-substituted polyamide such as methanol, ethanol, isopropyl alcohol, benzene, toluene, xylene, methyl Cellosolve, water, or the like.

The relief pattern formed is washed with a rinsing solution to remove the developing solution. As the rinsing solution, there can be used a non-solvent for the polyamide-acid or carboxyl-substituted polyamide having good compatibility with the developing solution. Examples of such non-solvents are methanol, ethanol, isopropyl alcohol, benzene, toluene, xylene, methyl Cellosolve, and the like. These non-solvents may be used alone or as a mixture thereof.

The polymer of the relief pattern is a precursor of polyimide and can be converted to heat resistant polyimide by heating at a temperature of 150°C to 450°C.

This invention is illustrated by way of the following Examples

Example 1

An amine solution was prepared by dissolving 100 g (0.5 mole) of 4,4′-diaminodiphenyl ether in 1791 g of N-methyl-2-pyrrolidone in a nitrogen stream. While maintaining the amine solution at about 15°C with ice cooling, 109 g (0.5 mole) of pyromellitic acid dianhydride was added thereto with stirring. After completion of the addition, the reaction was continued at about 15°C for additional 3 hours to give a solution (A) of a polyamide-acid having a repeating unit of the formula:

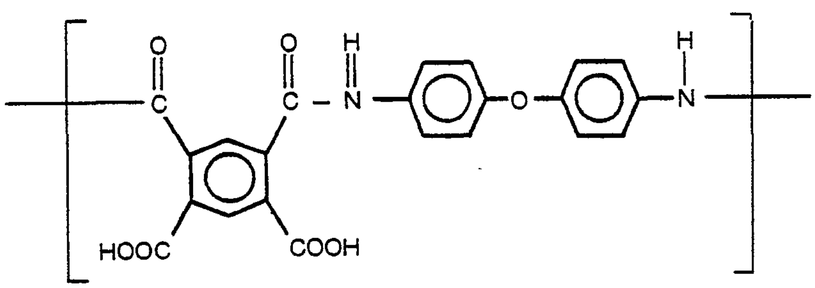

and having a viscosity of 6 Pa·s (30°C).

In 20 g of the solution (A), 1.57 g (0.01 mole) of 2-(N,N-dimethylamino)ethyl methacrylate and 0.37 g (0.001 mole) of 2,6-di(4′-azidebenzal)-4-methyl-cyclohexanone were dissolved and the resulting solution was filtered under pressure using a filter having pores of 5 μm.

The resulting solution was spin coated on a silicon wafer using a spinner and dried at 70°C for 30 minutes to give a coating film of 1.2 μm thick. The coating film was closely covered with a striped photo-mask made of soda glass and then irradiated with ultraviolet light from a 500 W Xe-Hg lamp. The intensity of ultraviolet light on the exposed surface was 25 mW/cm$^2$ in a wavelength region of 365 nm. After exposure to light, the coating film was developed with a mixed solution of N-methyl-2-pyrrolidone and ethanol (5:1 by volume), followed by rinsing with a rinsing solution (ethanol) to give a relief pattern. Changes of remaining film thickness with the lapse of time were measured and the sensitivity was determined in terms of an exposure dose which can give a value of 0.5 obtained by dividing the residual film thickness by the coated film thickness. The sensitivity was 118 mJ/cm$^2$. A relief pattern having sharp end surfaces with a minimum line width of 2 μm was obtained with an exposure dose of 3 times as large as the sensitivity. The pattern was not blurred even when heated at 400°C for 60 minutes.

Example 2

In 20 g of the solution (A) obtained in Example 1, 1.57 g (0.01 mole) of 2-(N,N-dimethylamino)ethyl methacrylate and 1.16 g (0.004 mole) of 4,4-diazidechalcone were dissolved. The resulting solution was filtered under pressure using a filter having pores of 5 µm.

The resulting solution was spin coated on a silicon wafer using a spinner and dried at 70°C for 30 minutes to give a coating film of 3.2 µm thick. The coating film was closely covered with a striped photomask and then irradiated with ultraviolet light from a 500 W high pressure mercury lamp. The intensity of ultraviolet light on the exposed surface was 20 mW/cm$^2$ in a wavelength region of 365 nm. After exposure to light, the coating film was developed with a mixed solution of N,N-dimethylacetamide and ethanol (5:1 by volume), followed by rinsing with ethanol to give a relief pattern having a minimum line width of 7 µm. The sensitivity was 180 mJ/cm$^2$. The pattern was not blurred even when heated at 400°C for 60 minutes.

Example 3

In 20 g of the solution (A) obtained in Example 1, 1.71 g (0.01 mole) of 3-(N,N-dimethylamino)propyl methacrylate and 0.39 g (0.001 mole) of 2,6-di(4′-azidebenzal)-4-methylolcyclohexanone were disssolved. The resulting solution was filtered under pressure using a filter having pores of 1 µm.

The resulting solution was spin coated on a silicon wafer substrate using a spinner and dried at 70°C for 30 minutes to give a coating film of 5.2 µm thick. The coating film was closely covered with a striped photomask made of soda glass and then irradiated with ultraviolet light from a 500 W high pressure mercury lamp. After exposure to light, the coating film was developed with a mixed solution of N-methyl-2-pyrrolidone and ethanol (4:1 by volume), followed by rinsing with ethanol to give a relief pattern having a minimum line width of 6 µm. The sensitivity was 7 mJ/cm$^2$. The pattern was not blurred even when heated at 400°C for 60 minutes.

Example 4

An amine solution was prepared by dissolving 90 g (0.45 mole) of 4,4′-diaminodiphenyl ether and 1.14 g (0.05 mole) of 4,4′-diaminodiphenyl ether 3-carbonamide in 1764 g of N-methyl-2-pyrrolidone in a nitrogen stream. While maintaining the amine solution at about 15°C with ice cooling, 54.5 g (0.25 mole) of pyromellitic acid dianhydride and 80.5 g (0.25 mole) of 3,3′,4,4′-benzophenonetetracarboxylic acid dianhydride were added thereto with stirring. After completion of the addition, the reaction was continued at about 15°C for additional 3 hours to give a solution (B) of a polyamide-acid having a repeating unit of the formula:

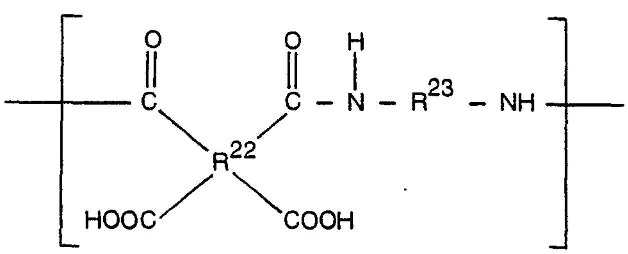

wherein $R^{22}$ is 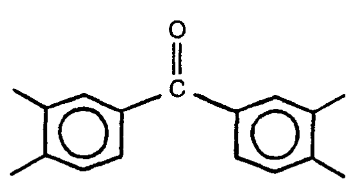 and 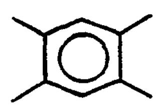 (1 : 1) ; and

$R^{23}$ is 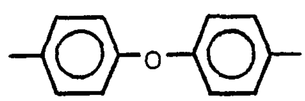 and 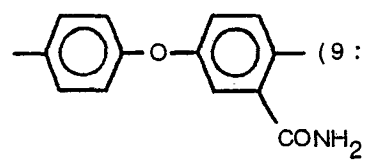 (9 : 1),

and having a viscosity of 5.5 pas (30°C).

In 20 g of the solution (B), 1.57 g (0.01 mole) of 2-(N,N-dimethylamino)ethyl methacrylate and 0.55 g (0.0015 mole) of 2,6-di(4′-azidebenzal)-4-methyl-cyclohexanone were dissolved. The resulting solution was filtered under pressure using a filter having pores of 5 µm.

The resulting solution was spin coated on a silicon wafer using a spinner and dried at 70°C for 30 minutes to give a coating film of 3.4 μm thick. The coating film was closely covered with a striped photomask made of soda glass and then irradiated with ultraviolet light from a 500 W high pressure mercury lamp. After exposure to light, the coating film was developed with a mixed solution of N-methyl-2-pyrrolidone and ethanol (5:1 by volume), followed by rinsing with ethanol to give a relief pattern having a minimum line width of 7 μm. The sensitivity was 100 $mJ/cm^2$. The pattern was not blurred even when heated at 400°C for 60 minutes.

Example 5

In a 20 g of the solution (B) obtained in Example 4, 1.71 g (0.01 mole) of 3-(N,N-dimethylamino)propyl methacrylate and 0.37 g (0.001 mole) of 2,6-di(azidebenzal)-4-hydroxycyclohexanone were dissolved. The resulting solution was filtered under pressure using a filter having pores of 1 μm.

The resulting solution was spin coated on a silicon wafer using a spinner and dried at 70°C for 30 minutes to give a coating film of 5.2 μm thick. The coating film was closely covered with a striped photomask made of soda glass and then irradiated with ultraviolet light from a 500 W high pressure mercury lamp. After exposure to light, the coating film was developed with a mixed solution of N-methyl-2-pyrrolidone and ethanol (4:1 by volume), followed by rinsing with ethanol to give a relief pattern having a minimum line width of 6 μm. The sensitivity was 8 $mJ/cm^2$. The pattern was not blurred even when heated at 400°C for 60 minutes.

Example 6

In 20 g of the solution (B) obtained in Example 4, 1.71 g (0.01 mole) of 3-(N,N-diethylamino)propyl methacrylate and 0.39 g (0.001 mole) of 2,6-di(4'-azidebenzal)-4-methoxycyclohexanone were dissolved. The resulting solution was filtered under pressure using a filter having pores of 1 μm.

The resulting solution was spin coated on a silicon wafer using a spinner and dried at 70°C for 30 minutes to give a coating film of 4.9 μm thick. The coating film was closely covered with a striped photomask made of soda glass and then irradiated with ultraviolet light from a 500 W high pressure mercury lamp. After exposure to light, the coating film was developed with a mixed solution of N-methyl-2-pyrrolidone and ethanol (4:1 by volume), followed by rinsing with ethanol to give a relief pattern having a minimum line width of 6 μm. The sensitivity was 15 $mJ/cm^2$. The pattern was not blurred even when heated at 400°C for 60 minutes.

Example 7

In 20 g of the solution (B) obtained in Example 4, 1.71 g (0.01 mole) of 3-(N,N-dimethylamino)propyl methacrylate and 0.39 g (0.001 mole) of 2,6-di(4'-azidebenzal)-4-methylolcyclohexanone were dissolved. The resulting solution was filtered under pressure using a filter having pores of 1 μm.

The resulting solution was spin coated on a silicon wafer using a spinner and dried at 70°C for 30 minutes to give a coating film of 5.2 μm thick. The coating film was closely covered with a striped photomask made of soda glass and then irradiated with ultraviolet light from a 500 W high pressure mercury lamp. After exposure to light, the coating film was developed with a mixed solution of N-methyl-2-pyrrolidone and ethanol (4:1 by volume), followed by rinsing with ethanol to give a relief pattern having a minimum line width of 6 μm. The sensitivity was 7 $mJ/cm^2$. The pattern was not blurred even when heated at 400°C for 60 minutes.

Example 8

In 20 g of the solution (A) obtained in Examples 1, 2.2 g (0.01 mole) of 2-(N,N-dimethylamino)ethyl cinnamate and 0.55 g (0.0015 mole) of 2,6-di(4'-azidebenzal)-4-methylcyclohexanone were dissolved. The resulting solution was filtered under pressure using a filter having pores of 5 μm.

The resulting solution was spin coated on a silicon wafer using a spinner and dried at 90°C for 30 minutes to give a coating film of 2.3 μm thick. The coating film was closely covered with a striped photomask made of soda glass and then irradiated with ultraviolet light from a 500 W high pressure mercury lamp. After exposure to light, the coating film was developed with a mixed solution of N-methyl-2-pyrrolidone and ethanol (5:1 by volume), followed by rinsing with ethanol to give a relief pattern having a minimum line width of 6 μm. The sensitivity was 350 $mJ/cm^2$. The pattern was not blurred even when heated at 400°C for 60 minutes.

Example 9

In 20 g of the solution (A) obtained in Example 1, 1.37 g (0.01 mole) of triallylamine and 0.55 g (0.0015 mole) of 2,6-di(4'-azidebenzal)-4-methylcyclohexanone were dissolved. The resulting solution was filtered under pressure using a filter having pores of 5 μm.

The resulting solution was spin coated on a silicon wafer using a spinner and dried at 90°C for 30 minutes to give a coating film of 3.5 μm thick. The coating film was closely covered with a striped photomask made of soda glass and then irradiated with ultraviolet light from a 500 W high pressure mercury lamp. After exposure to light, the coating film was developed with a mixed solution of N-methyl-2-pyrrolidone and ethanol (1:1 by volume), followed by rinsing with ethanol to give a relief pattern having a

minimum line width of 7 µm. The sensitivity was 900 mJ/cm². The pattern was not blurred even when heated at 400°C for 60 minutes.

Example 10

In 20 g of the solution (A) obtained in Example 1, 1.57 g (0.01 mole) of 2-(N,N-dimethylamino)ethyl methacrylate and 1.18 g (0.005 mole) of 4,4'-diazidebiphenyl were dissolved. The resulting solution was filtered under pressure using a filter having pores of 5 µm.

The resulting solution was spin coated on a silicon wafer using a spinner and dried at 70°C for 30 minutes to give a coating film of 3.2 µm thick. The coating film was closely covered with a striped photomask made of soda glass and then irradiated with ultraviolet light from a 500 W high pressure mercury lamp. After exposure to light, the coating film was developed with a mixed solution of N-methyl-2-pyrrolidone and ethanol (5:1 by volume), followed by rinsing with ethanol to give a relief pattern having a minimum line width of 6 µm. The sensitivity was 900 mJ/cm². The pattern was not blurred even when heated at 400°C for 60 minutes.

Example 11

In 20 g of the solution (B) obtained in Example 4, 1.57 g (0.01 mole) of 2-(N,N-dimethylamino)ethyl methacrylate and 1.85 g (0.005 mole) of 4,4'-diazidechalcone were dissolved. The resulting solution was filtered under pressure using a filter having pores of 5 µm.

The resulting solution was spin coated on a silicon wafer using a spinner and dried at 80°C for 30 minutes to give a coating film of 3.6 µm thick. The coating film was closely covered with a striped photomask made of soda glass and then irradiated with ultraviolet light from a 500 W high pressure mercury lamp. After exposure to light, the coating film was developed with a mixed solution of N-methyl-2-pyrrolidone and ethanol (5:1 by volume), followed by rinsing with ethanol to give a relief pattern having a minimum line width of 7 µm. The sensitivity was 160 mJ/cm². The pattern was not blurred even when heated at 400°C for 60 minutes.

Example 12

An amine solution was prepared by dissolving 90 g (0.45 mole) of 4,4'-diaminodiphenyl ether and 9.6 g (0.05 mole) of bis(3-aminopropyl)tetramethyldisiloxane in 1765 g of N-methyl-2-pyrrolidone in a nitrogen stream. While maintaining the amine solution at about 15°C with ice cooling, 54.5 g (0.25 mole) of pyromellitic acid dianhydride and 80.5 g (0.25 mole) of 3,3,'4,4'-benzophenonetetracarboxylic acid dianhydride were added thereto with stirring. After completion of the addition, the reaction was continued at about 15°C for additional 3 hours to give a solution (C) of polyamide-acid or carboxyl-substituted polyamide having a repeating unit of the formula:

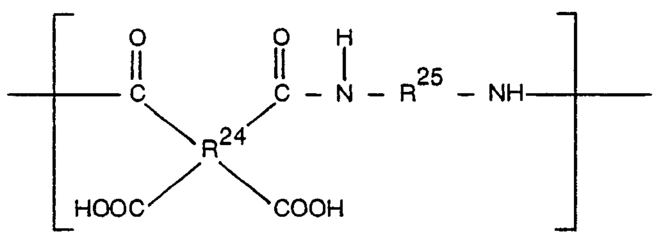

wherein $R^{24}$ is 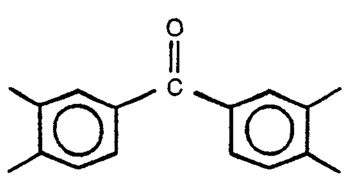 and 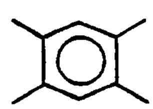 (1 : 1); and

$R^{25}$ is 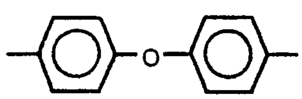 and 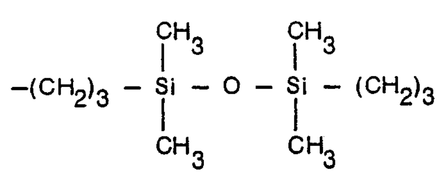 (9 : 1),

and having a viscosity of 5 Pa·s (30°C).

In 20 g of the solution (C), 1.57 g (0.01 mole) of 2-(N,N-dimethylamino)ethyl methacrylate and 0.55 g (0.0015 mole) of 4,4'-di(4'-azidebenzal)-4-methylcyclohexanone were dissolved. The resulting solution was filtered under pressure using a filter having pores of 5 µm.

The resulting solution was spin coated on a silicon wafer using a spinner and dried at 70°C for 30 minutes to give a coating film of 3.3 μm thick. The coating film was closely covered with a striped photomask made of soda glass and then irradiated with ultraviolet light from a 500 W high pressure mercury lamp. After exposure to light, the coating film was developed with a mixed solution of N-methyl-2-pyrrolidone and ethanol (5:1 by volume), followed by rinsing with ethanol to give a relief pattern having a minimum line width of 6 μm. The sensitivity was 110 mJ/cm$^2$. The pattern was not blurred even when heated at 400°C for 60 minutes.

Example 13

In 20 g of the solution (C) obtained in Example 12, 1.57 g (0.01 mole) of 2-(N,N-dimethylamino)ethyl methacrylate, 0.55 g (0.0015 mole) of 4,4'-di(4'-azidebenzal)-4-methylcyclohexanone, and 0.1 g of 1,9-benzanthrone as photosensitizer were dissolved. The resulting solution was filtered under pressure using a filter having pores of 5 μm.

The resulting solution was spin coated on a silicon wafer using a spinner and dried at 70°C for 30 minutes to give a coating film of 3.3 μm thick. The coating film was closely covered with a striped photomask made of soda glass and then irradiated with ultraviolet light from a 500 W high pressure mercury lamp. After exposure to light, the coating film was developed with a mixed solution of N-methyl-2-pyrrolidone and ethanol (5:1 by volume), followed by rinsing with ethanol to give a relief pattern having a minimum line width of 6 μm. The sensitivity was 80 mJ/cm$^2$, which value was increased by 30 mJ/cm$^2$ compared with that of Example 12. The pattern was not blurred even when heated at 400°C for 60 minutes.

Example 14

In 20 g of the solution (C) obtained in Example 12, 1.57 g (0.01 mole of 2-(N,N-dimethylamino)ethyl methacrylate, 0.55 g (0.0015 mole) of 2,6-di(4'-azidebenzal)cyclohexanone and 0.1 g of Michler's ketone as photosensitizer were dissolved. The resulting solution was filtered under pressure using a filter having pores of 5 μm.

The resulting solution was spin coated on a silicon wafer using a spinner and dried at 70°C for 30 minutes to give a coating film of 3.3 μm. The coating film was closely covered with a striped photo-mask made of soda glass and then irradiated with ultraviolet light from a 500 W high pressure mercury lamp. After exposure to light, the coating film was developed with a mixed solution of N-methyl-2-pyrrolidone and ethanol (5:1 by volume), followed by rinsing with ethanol to give a relief pattern having a minimum line width of 6 μm. The sensitivity was 75 mJ/cm$^2$, which value was increased by 35 mJ/cm$^2$ compared with that of Example 12. The pattern was not blurred even when heated at 400°C for 60 minutes.

Example 15

In 20 g of the solution (A) obtained in Example 1, 1.57 g (0.01 mole) of 2-(N,N-dimethylamino)ethyl methacrylate and 0.37 g (0.001 mole) of 2,6-di(4'-azidebenzal)-4-hydroxycyclohexanone were dissolved. The resulting solution was filtered under pressure using a filter having pores of 5 μm.

The resulting solution was spin coated on a silicon wafer using a spinner and dried at 70°C for 30 minutes to give a coating film of 1.2 μm thick. The coating film was closely covered with a striped photomask made of soda glass and then irradiated with ultraviolet light from a 500 W Xe—Hg lamp. The intensity of ultraviolet light on the exposed surface was 8 mW/cm$^2$ in a wavelength region of 365 nm. After exposure to light, the coating film was developed with a mixed solution of N-methyl-2-pyrrolidone and ethanol (4:1 by volume), followed by rinsing with ethanol to give a relief pattern having a minimum line width of 2 μm. The sensitivity was 40 mJ/cm$^2$. The pattern was not blurred even when heated at 400°C for 60 minutes.

Example 16

In 20 g of the solution (C) obtained in Example 12, 1.57 g (0.01 mole) of 2-(N,N-dimethylamino)ethyl methacrylate and 0.42 g (0.001 mole) of 2,6-di(4'azidecinnamylidene)-4-hydroxyclohexanone were dissolved. The resulting solution was filtered under pressure using a filter having pores of 5 μm.

The resulting solution was spin coated on a silicon wafer using a spinner and dried at 70°C for 30 minutes to give a coating film of 3.3 μm thick. The coating film was closely covered with a striped photomask made of soda glass and then irradiated with ultraviolet light from a 500 W high pressure mercury lamp. After exposure to light, the coating film was developed with a mixed solution of N-methyl-2-pyrrolidone and ethanol (5:1 by volume), followed by rinsing with ethanol to give a relief pattern having a minimum line width of 6 μm. The sensitivity was 35 mJ/cm$^2$. The pattern was not blurred even when heated at 400°C for 60 minutes.

In the above-mentioned Examples, the adhesion of the polyimide coating films to the substrates were improved in any cases.

Example 17

In a 500-ml four-necked flask equipped with a thermometer, a stirrer, a calcium chloride tube and a nitrogen introducing pipe, 20 g (0.1 mole) of 4,4'-diaminodiphenyl ether was dissolved in 500 g of N-methyl-2-pyrrolidone in a nitrogen stream to give an amine solution. While maintaining the amine solution at about 15°C with ice cooling, 43.6 g (0.2 mole) of pyromellitic acid dianhydride was added gradually

thereto and reacted for 2 hours. To this, 25.2 g (0.1 mole) of 4,4'-diphenylether diisocyanate, said amount being equivalent to the amount of the acid anhydride group, was added and the temperature was raised to 75°C. Then, 0.1 g of benzyldimethylamine was added to the reaction solution and the reaction was carried out for 3 hours while removing carbon dioxide liberated to give a solution (D) of polyamideimidecarboxylic acid having a repeating unit of the formula:

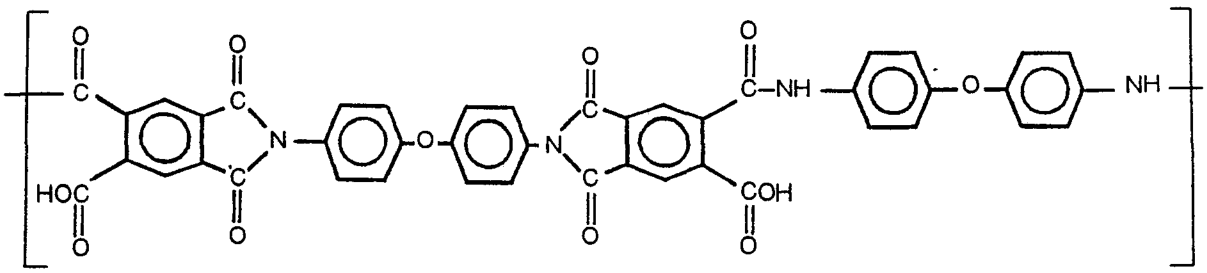

and having a viscosity of 15 poises (25°C).

In 20 g of the solution (D), 1.57 g (0.01 mole) of 2-(N,N-dimethylamino)ethyl methacrylate and 0.28 g (0.008 mole) of 2,6-di(4'-azidebenzal)-4-hydroxycyclohexanone were dissolved. The resulting solution was filtered under pressure using a filter having pores of 1 μm.

The resulting solution was spin coated on a silicon wafer using a spinner and dried at 70°C for 30 minutes to give a coating film of 2 μm thick. The coating film was closely covered with a striped photomask made of soda glass and then irradiated with ultraviolet light from a 500 W Xe—Hg lamp. The intensity of the ultraviolet light on the exposed surface was 8 mW/cm$^2$ in a wavelength region of 365 nm. After exposure to light, the coating film was developed with a mixed solution of N-methyl-2-pyrrolidone and ethanol (4:1 by volume), followed by rinsing with ethanol to give a relief pattern having a minimum line width of 3 μm. When an exposure dose at which the film thickness after development became ½ of the initial film thickness was taken as sensitivity, the sensitivity was 40 mJ/cm$^2$. The pattern was not blurred even when heated at 400°C for 60 minutes.

Example 18

In 20 g of the solution (D) obtained in Example 17, 1.3 g (0.009 mole) of 3-(N,N-dimethylamino)propyl methacrylate and 0.28 g (0.0008 mole) of 2,6-di(4'-azidebenzal)-4-hydroxycyclohexanone were dissolved. The resulting solution was filtered under pressure using a filter having pores of 1 μm.

The resulting solution was spin coated on a silicon wafer using a spinner and dried at 70°C for 30 minutes to give a coating film of 4 μm thick. The coating film was closely covered with a striped photomask made of soda glass and then irradiated with ultraviolet light from a 500 W high pressure mercury lamp. The intensity of the ultraviolet light on the exposed surface was 4 mW/cm$^2$ in a wavelength region of 365 nm. After exposure to light, the coating film was developed with a mixed solution of N,N-dimethylacetamide and ethanol (4:1 by volume), followed by rinsing with ethanol to give a relief pattern having a minimum line width of 5 μm. The sensitivity was 20 mJ/cm$^2$. The pattern was not blurred even when heated at 400°C for 60 minutes.

Example 19

In the same flask as used in Example 17, 170 g of N-methyl-2-pyrrolidone was placed, followed by addition of 0.729 g (0.003 mole) of 4,4'-diaminodiphenylether-3-carbonamide and 5.4 g (0.027 mole) of 4,4'-diaminodiphenyl ether and stirring for 15 minutes. Subsequently 9.66 g (0.03 mole) of 3,3',4,4'-benzophenonetetracarboxylic acid dianhydride and 6.54 g (0.03 mole) of pyromellitic acid dianhydride were gradually added to the reaction solution and the reaction was continued at room temperature for 2 hours. To this, 7.56 g (0.03 mole) of 4,4'-diphenylether diisocyanate, said amount being equivalent to the amount of the acid anhydride group, was added and the temperature was raised to 75°C. Then, 0.1 g of benzyldimethylamine was added to the reaction solution and the reaction was carried out for 3 hours while removing carbon dioxide liberated to give a solution (E) of polyamideimidecarboxylic acid having a repeating unit of the formula:

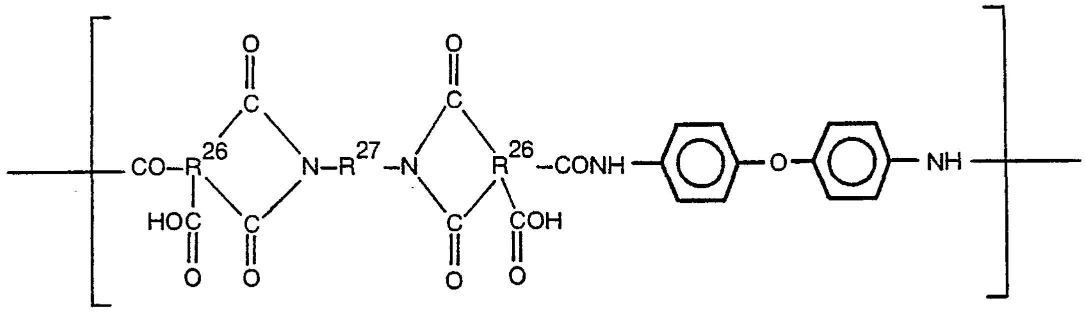

wherein $R^{26}$ is 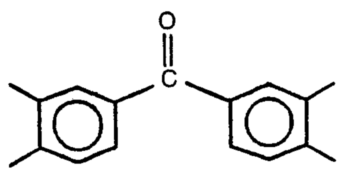 and 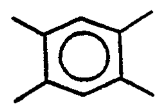 (1 : 1) ; and

$R^{27}$ is 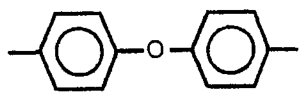 and 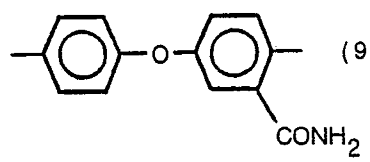 (9 : 1),

and having a viscosity of 1.5 Pa·s (25°C).

In 20 g of the solution (E), 1.6 g (0.009 mole) of 3-(N,N-dimethylamino)propyl methaa-crylate and 0.35 g (0.0009 mole) of 2,6-di(4'-azidebenzal)-4-hydroxycyclohexanone were dissolved. The resulting solution was filtered under pressure using a filter having pores of 1 μm.

The resulting solution was spin coated on a silicon wafer using a spinner and dried at 70°C for 30 minutes to give a coating film of 2 μm thick. The coating film was closely covered with a striped photomask made of soda glass and then irradiated with ultraviolet light from a 500 W high pressure mercury lamp. The intensity of the ultraviolet light on the exposed surface was 4 $mW/cm^2$ in a wavelength region of 365 nm. After exposure to light, the coating film was developed with a mixed solution of N-methyl-2-pyrrolidone and ethanol (4:1 by volume), followed by rinsing with ethanol to give a relief pattern having a minimum line width of 3 μm. The sensitivity was 20 $mJ/cm^2$. The pattern was not blurred even when heated at 400°C for 60 minutes.

Comparative Example 1

For comparison, a composition containing a polymer having a polyamide-acid or carboxyl-substituted polyamide as a major component and a compound having a carbon-carbon double bond which can be dimerized or polymerized by actinic light and an amino group or its quaternary salt was used.

In 20 g of the solution (A) obtained in Example 1, 1.57 g (0.01 mole) of 2-(N,N-dimethylamino)ethyl methacrylate was dissolved. The resulting solution was filtered under pressure using a filter having pores of 5 μm.

The resulting solution was spin coated on a silicon wafer using a spinner and dried at 70°C for 30 minutes to give a coating film of 3.2 μm thick. The coating film was closely covered with a striped photomask made of soda glass and then irradiated with ultraviolet light from a 500 W high pressure mercury lamp. After exposure to light, the coating film was developed with a mixed solution of N-dimethylacetamide and ethanol (5:1 by volume), followed by rinsing with ethanol to give a relief pattern having a minimum line width of 6 μm. The sensitivity was 3200 $mJ/cm^2$, which value was by far lower than those of Examples 1 to 19.

Comparative Example 2

For comparison, a heat resistant photosensitive polymer composition containing a polyamide-acid or carboxyl-substituted polyamide wherein a group having an unsaturated bond (e.g. a vinyl group) has been introduced to the carboxyl group by an amide bonding and a bisazide compound was used.

To 20 g of the solution (A) obtained in Example 1, 2 g (0.02 mole) of triethylamine and 7 g (0.02 mole) of hexachlorocyclotriphosphatriazene were added and stirred at room temperature for 1 hour. Subsequently, 1.29 g (0.01 mole) of 2-aminoethyl methacrylate was added thereto and stirred for 3 hours, followed by dissolving of 0.42 g (0.001 mole) of 2,6-di(4'-azidecinnamilydene)-4-hydroxycyclohexanone. The resulting solution was filtered under pressure using a filter having pores of 5 μm.

The resulting solution was spin coated on a silicon wafer using a spinner and dried at 60°C for 30 minutes to give a coating film of 1.2 μm thick. The coating film was closely covered with a striped photomask and then irradiated with ultraviolet light from a 500 W high pressure mercury lamp. The intensity of the ultraviolet light on the exposed surface was 8 mW/cm$^2$ in a wavelength region of 365 nm. After exposure to light for ten minutes, the coating film was developed with a mixed solution of N-methyl-2-pyrrolidone and ethanol (4:1 by volume), followed by rinsing with ethanol to give a relief pattern.

The degree of resolution was remarkably lower than those of Examples 1 to 19 and the obtained relief pattern had corrugated side surfaces and a minimum line width of as broad as 1000 μm.

As mentioned above, when the light-sensitive polymer composition of this invention is used, the sensitivity and the degree of resolution are improved remarkably compared with those of known compositions. Thus, the light-sensitive polymer composition of this invention can be applied as insulating films between semiconductor multi-layer wiring boards, heat resistant resists, and the like.

**Claims**

1. A light-sensitive polymer composition comprising
(a) 100 parts by weight of a polyamide-acid or carboxyl-substituted polyamide,
(b) 0.1 to 100 parts by weight of a bisazide,
(c) 1 to 400 parts by weight of at least one amine selected from the group consisting of amines containing at leat one unsaturated bond in each molecule.

2. A composition according to Claim 1, which further comprises
(d) a photosensitizer.

3. A composition according to Claim 1 or 2, wherein the bisazide (b) is at least one member selected from the group consisting of:

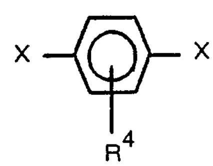
(4)

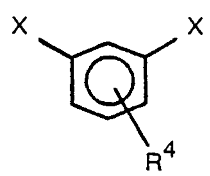
(5)

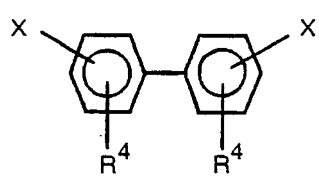
(6)

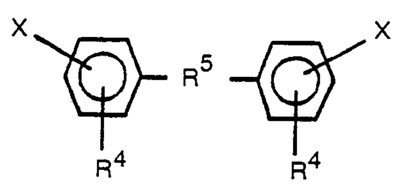
(7)

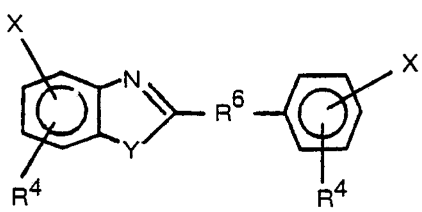
(8)

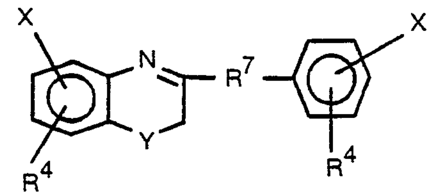

(9)

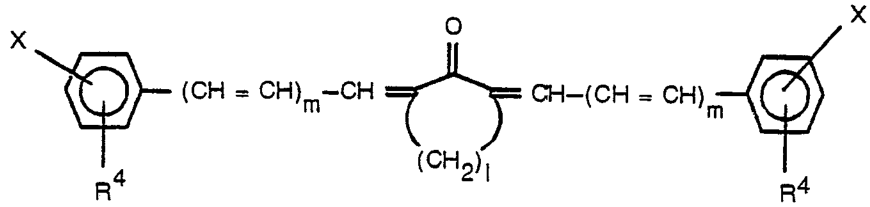

(10)

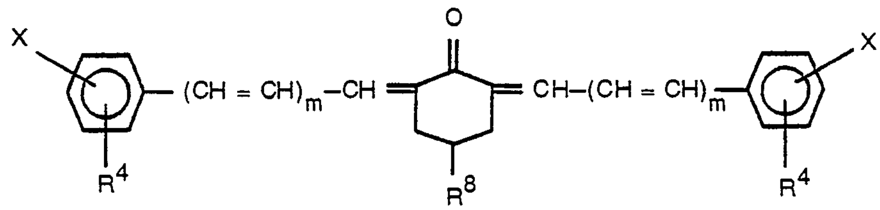

(11)

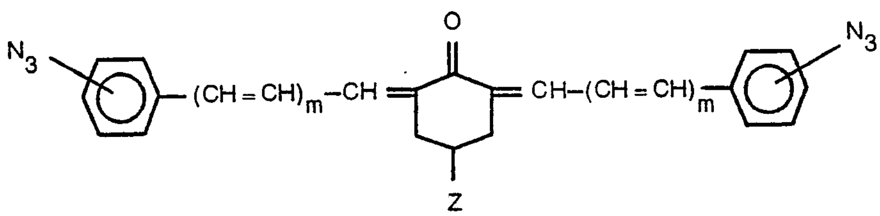

(12)

wherein X is —$N_3$ or $SO_2N_3$; $R^4$ is hydrogen, a $C_1$—$C_6$ alkyl group, —OH, —$OCH_3$, —COOH, —$SO_3H$, —$NO_2$ or a halogen and each $R^4$ may be the same or different; $R^5$, $R^6$ and $R^7$ are independently an alkylene group,

$-SO_2-$, $-S-$, $-O-$,

$-NH-$, 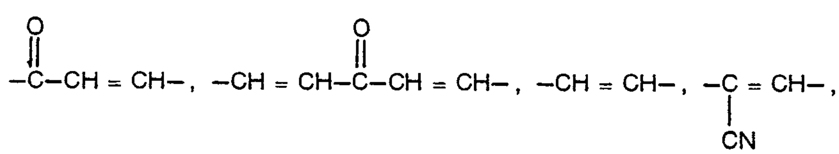

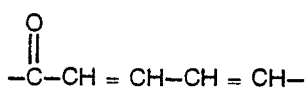 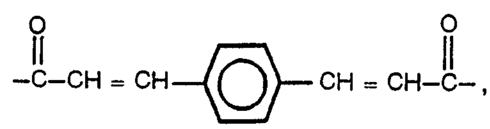

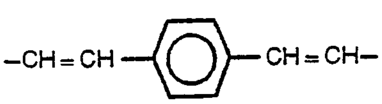 , 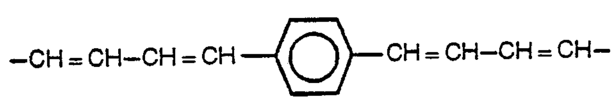 ,

$-CH=N-N=CH-$ , $-CH=N-(CH_2)_k-N=CH-$ , 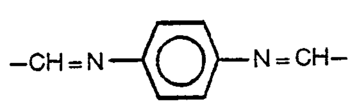 ,

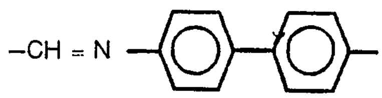, 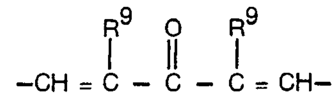,

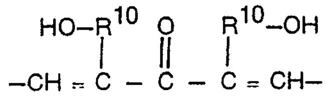, $-O-(CH_2)_k-O-$ or 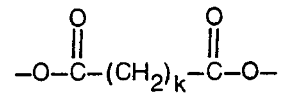;

$R^8$ is $-OH$, $-OR^9$, 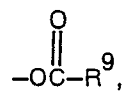, $-R^{10}-OH$, 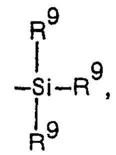, $-NH$, 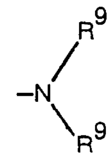,

$-COOH$, or $-COOR^9$; Y is —O—, —S—, or —NH—; l is an integer of 1 to 5;

m is zero or 1; Z is $-OH$, $-OR^9$, $-R^{10}-OH$, 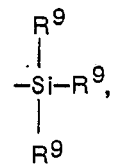, $-COOH$, $-COOR^9$, 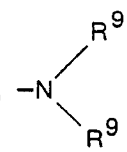 or $-NH_2$;

$R^9$ is a $C_1$—$C_6$ alkyl group; and $R^{10}$ is an alkylene group.

4. A composition according to Claim 1, 2 or 3, wherein the amine (c) is at least one member selected from the group consisting of:

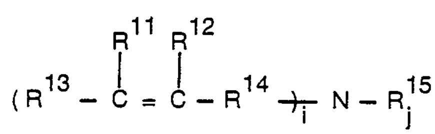 (13)

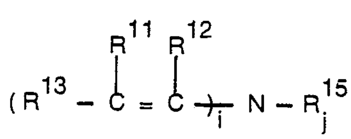 (14)

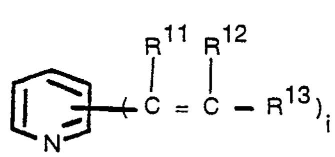 (15)

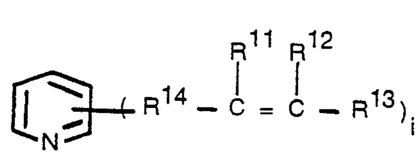 (16)

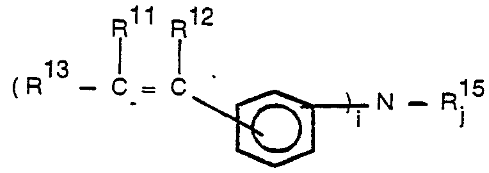

(17)

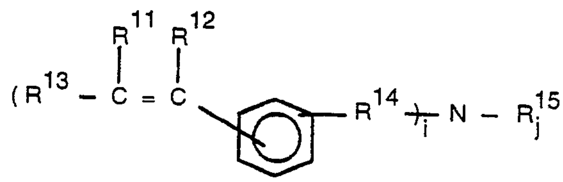

(19)

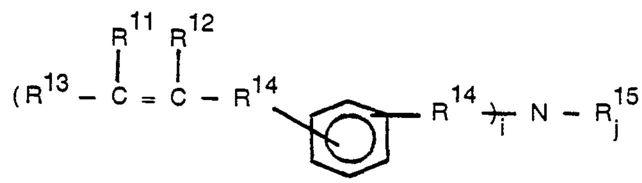

(20)

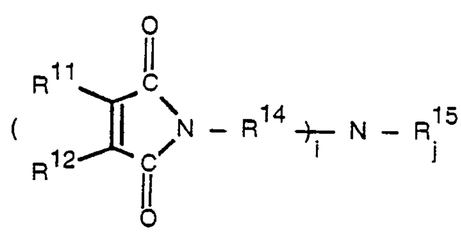

(21)

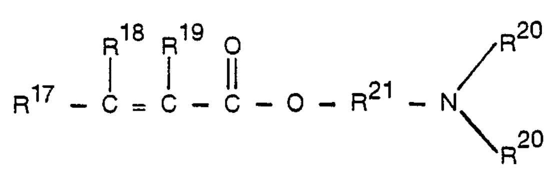

(22)

wherein $R^{11}$, $R^{12}$, $R^{13}$ and $R^{15}$ are independently hydrogen, a $C_1$—$C_6$ alkyl group, a phenyl group, or a vinyl group; $R^{14}$ is an alkylene group; i is an integer of 1 to 3, j is zero or an integer of 1 or 2 and $i + j = 3$; $R^{17}$, $R^{18}$ and $R^{19}$ are independently hydrogen, a $C_1$—$C_6$ alkyl group, a phenyl group or a vinyl group; $R^{20}$ is hydrogen, a $C_1$—$C_6$ alkyl group or a vinyl group; and $R^{21}$ is an alkylene group.

5. A composition according to any one of the preceding claims wherein the polyamide-acid or carboxyl-substituted polyamide (a) is one having as a major component a repeating unit of the formula

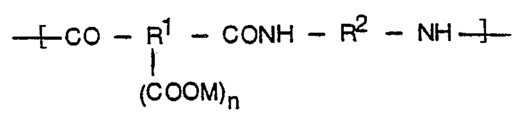

(1)

wherein $R^1$ is a trivalent or tetravalent organic group having at least 2 carbon atoms; $R^2$ is a divalent organic group having at least 2 carbon atoms; M is hydrogen, an alkali metal or an ammonium ion; and n is an integer of 1 or 2.

6. A composition according to any one of the preceding claims wherein the bisazide (b) is

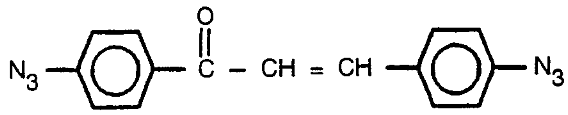

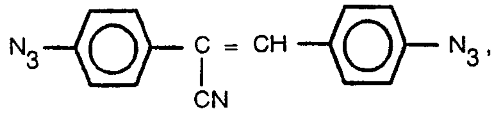

or

one represented by the formula:

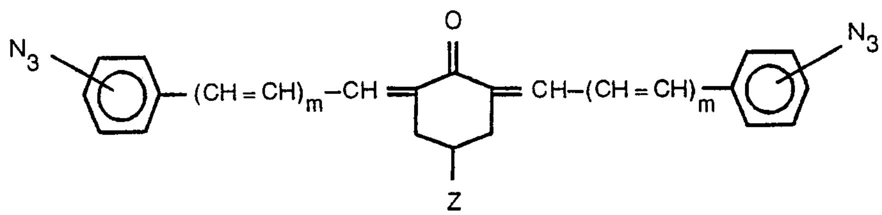

(12)

wherein Z is

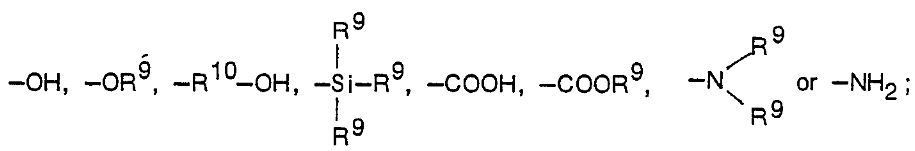

$R^9$ is a $C_1$—$C_6$ alkyl group; $R^{10}$ is an alkylene group; and m is zero or 1.

7. A composition according to any one of the preceding claims wherein the amine (c) is one represented by the formula:

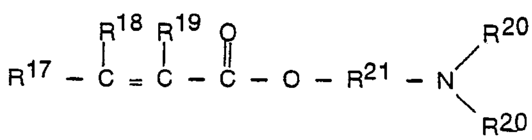

(24)

wherein $R^{17}$, $R^{18}$ and $R^{19}$ are independently hydrogen, a $C_1$—$C_6$ alkyl group, a phenyl group or a vinyl group; $R^{20}$ is hydrogen, a $C_1$—$C_6$ alkyl group or a vinyl group; and $R^{21}$ is an alkylene group.

8. A composition according to any one of the preceding claims wherein the polyamide-acid or carboxyl-substituted polyamide is one having as a major component a repeating unit of the formula:

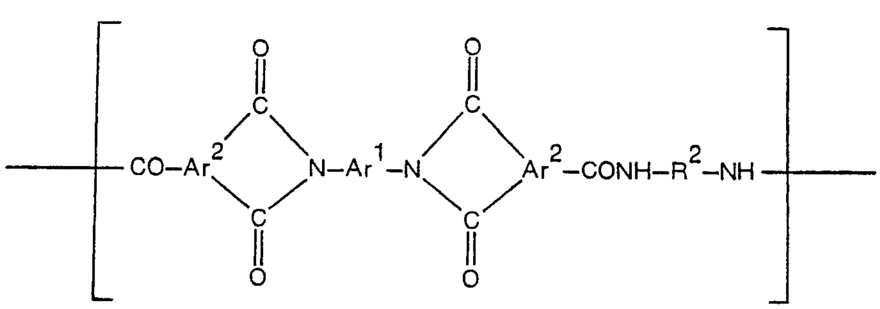

wherein $R^2$ is an aromatic ring-containing group, a silicon-containing group or a heterocyclic ring-containing group of the formula:

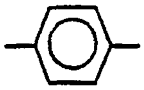 , 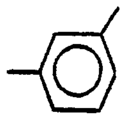 , 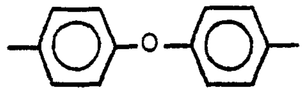 , 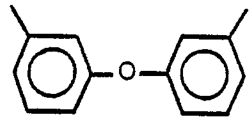 ,

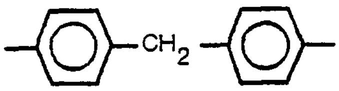 , 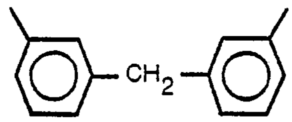 , 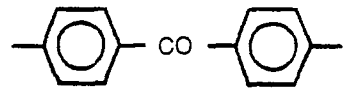 ,

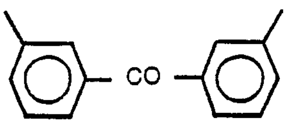 , 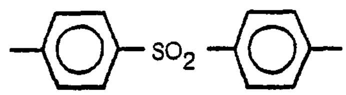 , 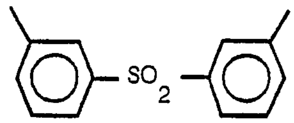 ,

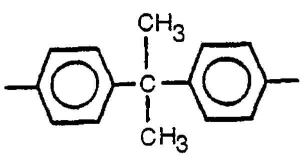 , 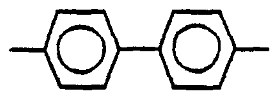 , 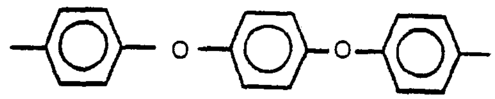 ,

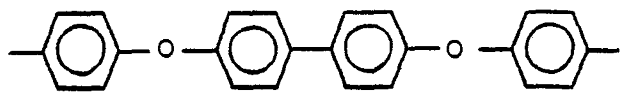 ,

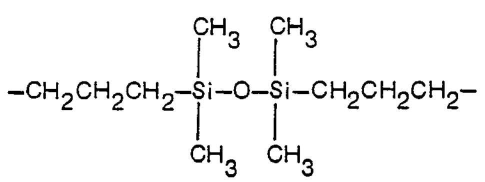 ,

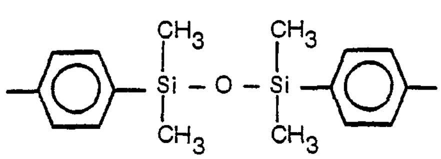 , or 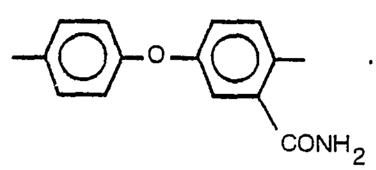 .

$Ar^1$ is one member selected from the group consisting of

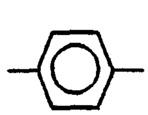 , 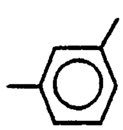 , 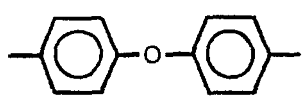 , 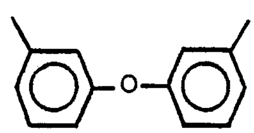 ,

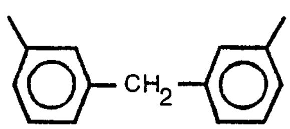 , 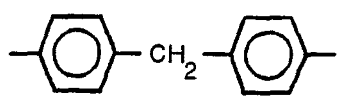 ,

and each $Ar^2$ independently is selected from the group consisting of

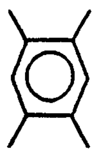, 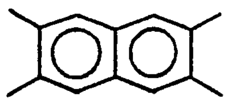, 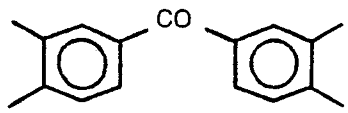, 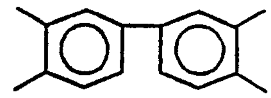,

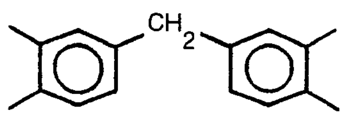, 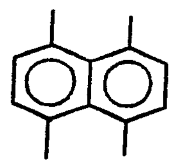, and 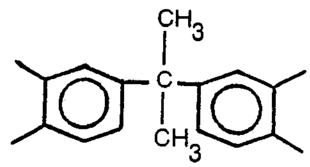,

wherein three bonding lines are bonded to the three carbonyl groups of the polymer main chain and the remainder one is bonded to a COOM group wherein M is as defined in claim 5.

9. A composition according to any one of the preceding claims wherein the bisazide (b) is at least one member selected from the group consisting of

2,6-di(4'-azidebenzal)-4-methylcyclohexanone,
4,4-diazidechalcone,
2,6-di(4'-azidebenzal-4-hydroxycyclohexane,
2,6-di(4'-azidebenzal)-4-methoxycyclohexanone,
2,6-di(4'-azidebenzal)-4-methylolcyclohexanone,
2,6-di(4'-azidebenzal)-4-trimethylsilylcyclohexanone,
$\alpha_d$-cyano-4,4'-diazidestilbene, and
2,6-di(4'-azidecinnamylidene)-4-hydroxycyclohexanone.

10. A composition according to any one of the preceding claims wherein the amine (c) is 3-(N,N-dimethylamino)propyl methacrylate, 4-(N,N-dimethylamino)butyl methacrylate or 3-(N,N-dimethylamino)-propyl cinnamate.

11. A composition according to Claim 10, wherein the amine (c) is 4-(N,N-dimethylamino)butyl methacrylate or 3-(N,N-dimethylamino)propyl methacrylate and the bisazide (b) is 2,6-di(4'-azidebenzal)-4-methylolcyclohexanone, 2,6-di(4'-azidebenzal-4-methoxycyclohexanone, or $\alpha_d$-cyano-4,4'-diazidestilbene.

12. A process for forming a relief pattern on a substrate comprising image-wise exposing the substrate and developing the image characterized by applying a composition as claimed in any one of claims 1 to 11 to the substrate prior to exposure.

**Patentansprüche**

1. Lichtempfindliche Polymerzusammensetzung, enthaltend
(a) 100 Gew.-Teile einer Polyamidsäure oder eines Carboxyl-substituierten Polyamids,
(b) 0,1 bis 100 Gew.-Teile eines Bisazids und
(c) 1 bis 400 Gew.-Teile mindestens eines Amins, ausgewählt aus der Gruppe der Amine, die mindestens eine ungesättigte Bindung in jedem Molekül aufweisen.

2. Zusammensetzung nach Anspruch 1, die zusätzlich
(d) eine Photosensibilisator enthält.

3. Zusammensetzung nach Anspruch 1 oder 2, in der das Bisazid (b) mindestens eine Verbindung aus der folgenden Verbindungsgruppe ist:

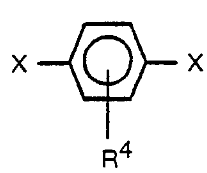 (4)

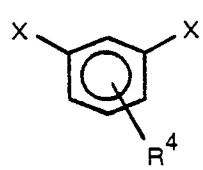 (5)

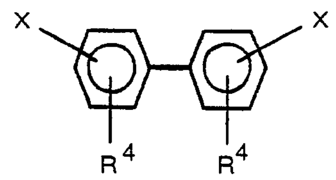

(6)

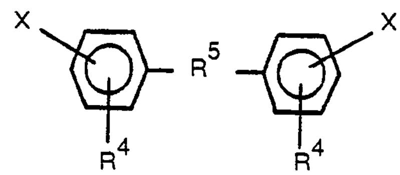

(7)

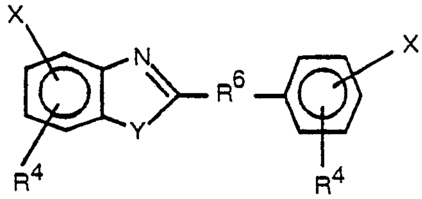

(8)

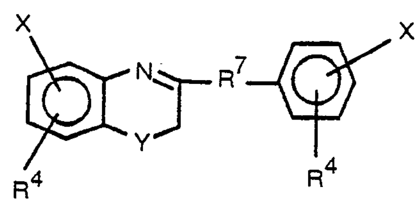

(9)

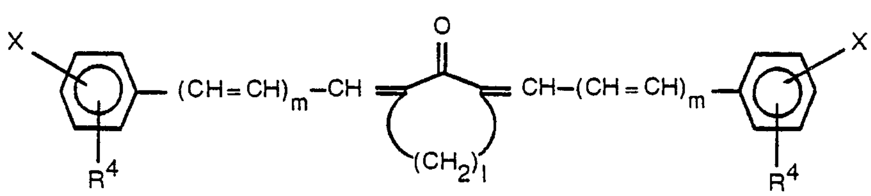

(10)

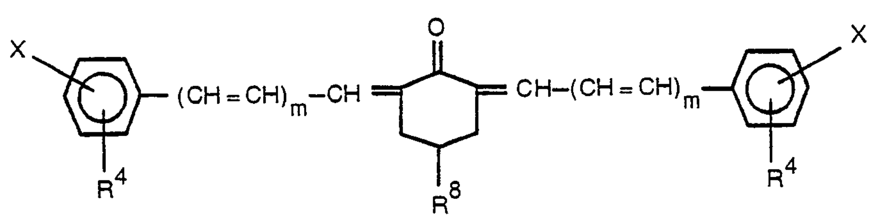

(11)

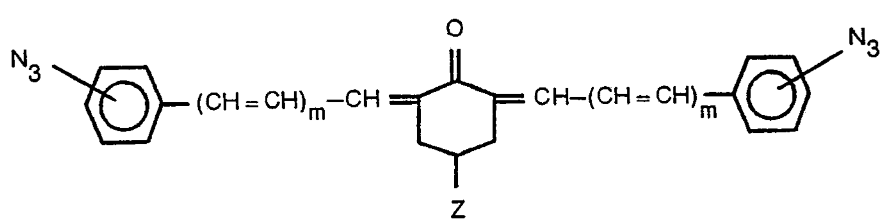

(12)

worin X $-N_3$ oder $-SO_2N_3$ bedeutet; $R^4$ für ein Wasserstoff atom, eine $C_1-C_6$-Alkylgruppe, —OH, $-OCH_3$, —COOH, $-SO_3H$, $-NO_2$ oder ein Halogenatom steht und die Reste $R^4$ jeweils gleich oder verschieden sein können; $R^5$, $R^6$ und $R^7$ unabhängig voneinander für eine Alkylengruppe,

$-SO_2-$, $-S-$, $-O-$,

$-NH-$, 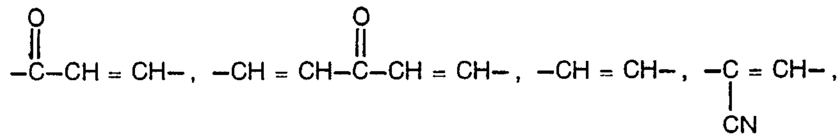

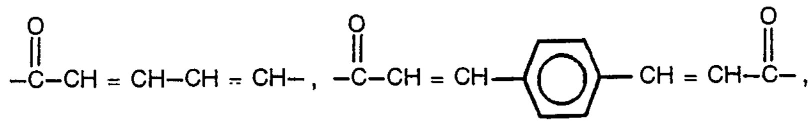

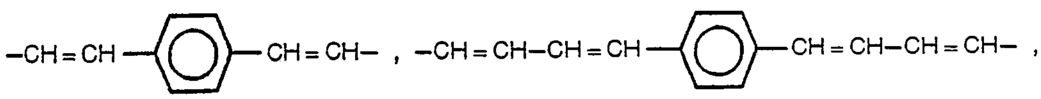

$-CH=N-N=CH-$ , $-CH=N-(CH_2)_k-N=CH-$ , 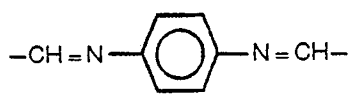

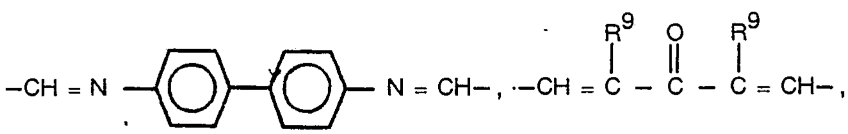

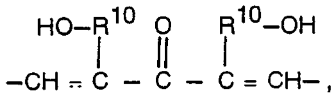 $-O-(CH_2)_k-O-$ or 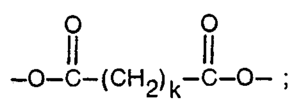

stehen

$R^8$ is $-OH$, $-OR^9$, 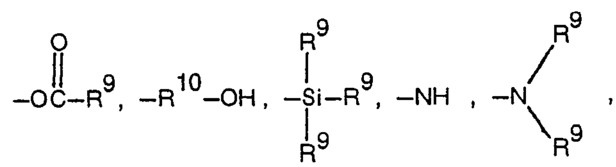

$-COOH$, or $-COOR^9$ ;

Y für —O—, —S— oder —NH— steht; 1 eine ganze Zahl von 1 bis 5; m 0 oder 1,

Z $-OH$, $-OR^9$, $-R^{10}-OH$, 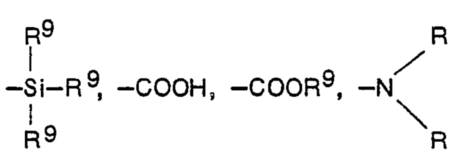 oder $-NH_2$ bedeuten;

eine $C_1-C_6$-Alkylgruppe und $R^{10}$ eine Alkylengruppe ist.

4. Zusammensetzung nach Anspruch 1, 2 oder 3, in der das Amin (c) mindestens eine Verbindung aus der nachstehenden Verbindungsgruppe ist:

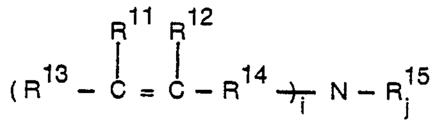

(13)

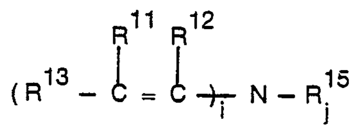

(14)

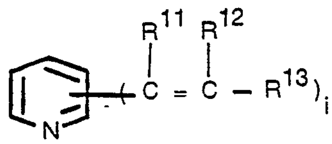

(15)

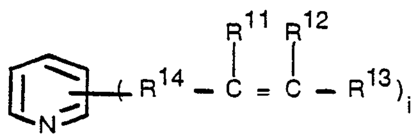

(16)

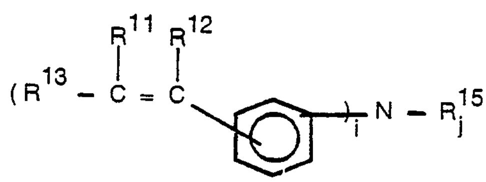

(17)

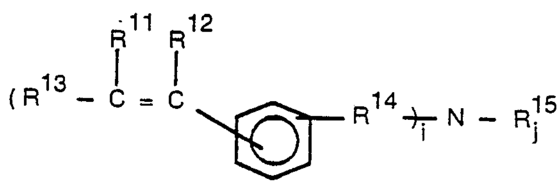

(19)

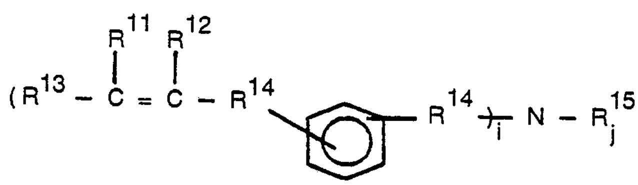

(20)

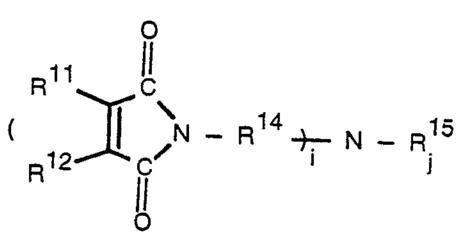

(21)

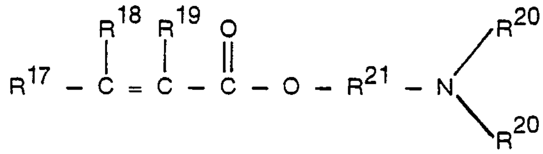

(22)

worin $R^{11}$, $R^{12}$, $R^{13}$ und $R^{15}$ unabhängig voneinander ein Wasserstoffatom, eine $C_1$—$C_6$—Alkylgruppe, eine Phenylgruppe oder eine Vinylgruppe bedeuten; $R^{14}$ eine Alkylengruppe ist; i eine ganze Zahl von 1 bis 3 ist, j für 0 oder eine ganze Zahl von 1 oder 2 steht und i + j = 3; $R^{17}$, $R^{28}$ und $R^{19}$ unabhängig voneinander für ein Wasserstoffatom, eine $C_1$—$C_6$—Alkylgruppe, eine Phenylgruppe oder eine Vinylgruppe stehen; $R^{20}$ ein Wasserstoffatom, eine $C_1$—$C_6$—Alkylgruppe oder eine Vinylgruppe und $R^{21}$ eine Alkylengruppe bedeuten.

5. Zusammensetzung nach einem der vorhergehenden Ansprüche, in der die Polyamidsäure oder das Carboxyl-substituierte Polyamid (a) als Hauptbestandteil eine wiederkehrende Einheit der Formel:

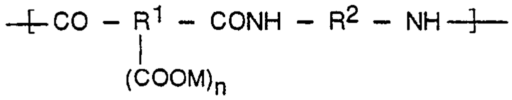

(1)

enthält, in der $R^1$ eine dreiwertige oder vierwertige organische Gruppe mit mindestens 2 Kohlenstoffatomen; $R^2$ eine zweiwertige organische Gruppe mit mindestens 2 Kohlenstoffatomen; M ein Wasserstoffatom, ein Alkalimetall- oder Ammoniumion und n eine ganze Zahl von 1 oder 2 bedeuten.

6. Zusammensetzung nach einem der vorhergehenden Ansprüche, in der das Bisazid (b) eine der Verbindungen

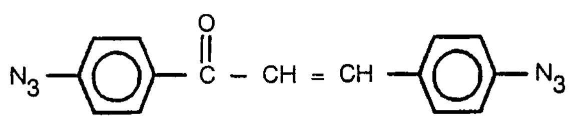

,

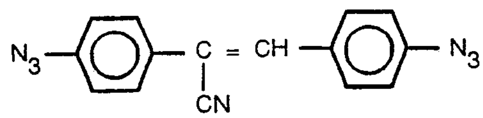

,

oder eine Verbindung der Formel

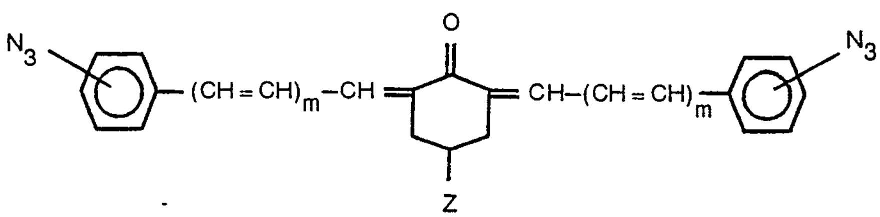

(12)

ist, worin Z für

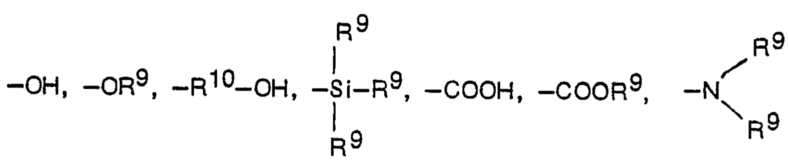

oder $-NH_2$ steht;

$R^9$ eine $C_1$—$C_6$—Alkylgruppe, $R^{10}$ eine Alkylengruppe un m 0 oder 1 bedeuten.

7. Zusammensetzung nach einem der vorhergehenden Ansprüche, in der das Amin (c) eine Verbindung der Formel

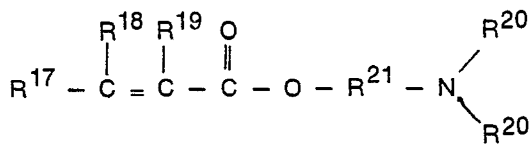

(24)

ist, worin $R^{17}$, $R^{18}$ und $R^{19}$ unabhängig voneinander ein Wasserstoffatom, eine $C_1$—$C_6$—Alkylgruppe, eine Phenylgruppe oder eine Vinylgruppe, $R^{20}$ ein Wasserstoffatom, eine $C_1$—$C_6$—Alkylgruppe oder eine Vinylgruppe und $R^{21}$ eine Alkylengruppe bedeuten.

8. Zusammensetzung nach einem der vorhergehenden Ansprüche, in der die Polyamidsäure oder das Carboxylsustituierte Polyamid eine Verbindung ist, die als Hauptbestandteil eine widerkehrende Einheit der nachstehenden Formel enthält

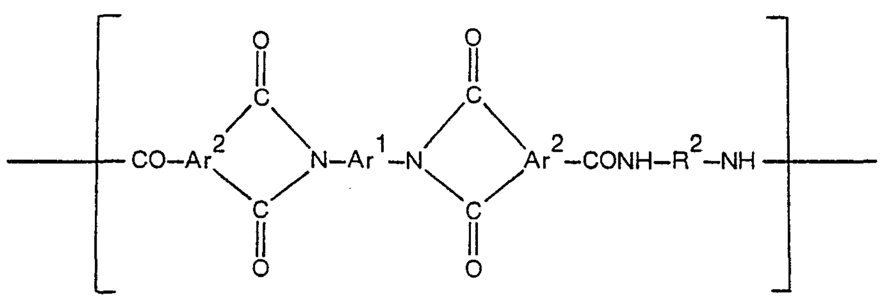

in der $R^2$ eine Gruppe, die einen aromatischen Ring enthält, eine Silicium enthaltende Gruppe oder eine einen heterocyclischen Ring enthaltende Gruppe der nachstehenden Formeln ist:

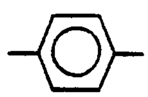 , 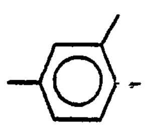 , 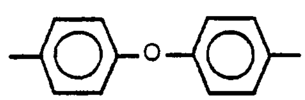 , 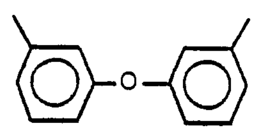 ,

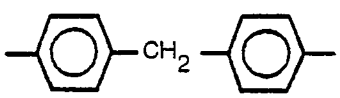 , 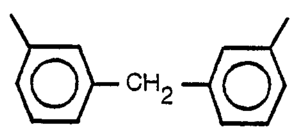 , 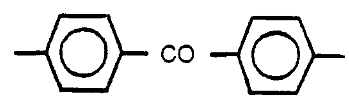 ,

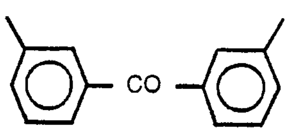 , 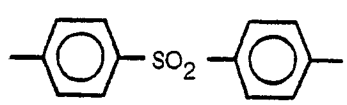 , 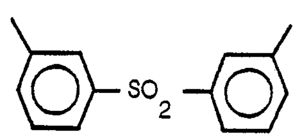 ,

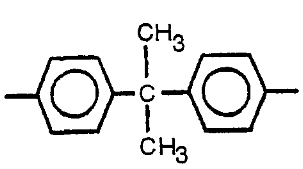 , 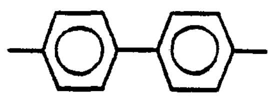 , 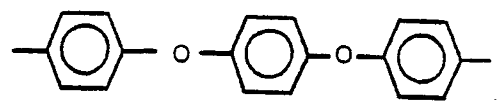 ,

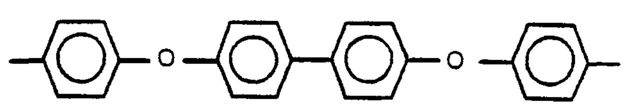 ,

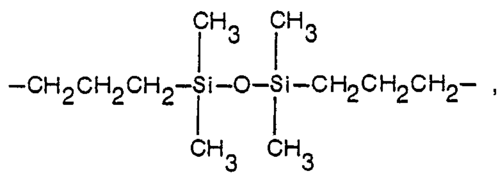

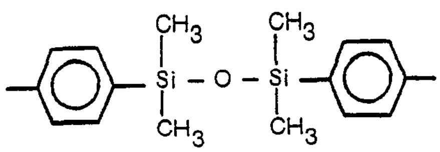 , oder 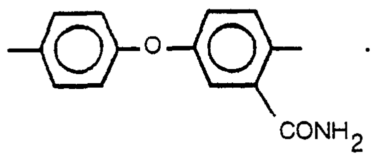 .

Ar[1] eine der nachstehenden Gruppen bedeutet:

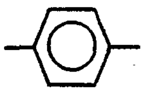 , 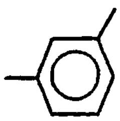 , 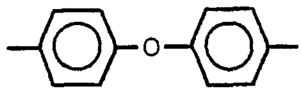 , 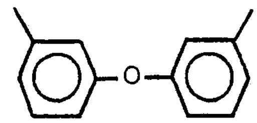 ,

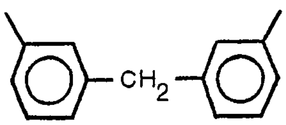 , 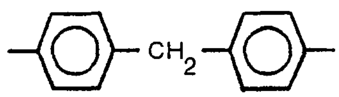 ,

und wobei jeder Reste Ar[2] unabhängig von den anderen aus nachstehenden Gruppen ausgewählt ist:

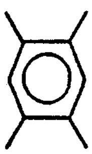 , 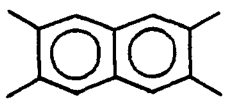 , 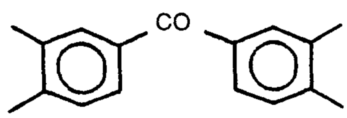 , 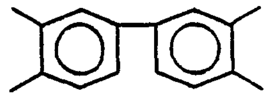 ,

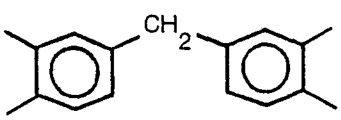 , 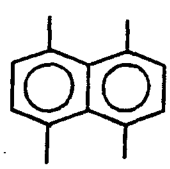 , und 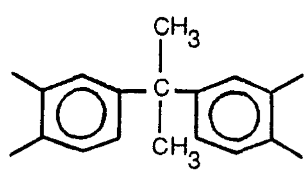 ,

worin drei Bindungen mit den drei Carboxylgruppen der Polymerhauptkette und die verbleibende Bindungen mit einer Gruppe COOM verknüpft sind, worin M die Definition gemäß Anspruch 5 hat.

9. Zusammensetzung nach einem der vorhergehenden Ansprüche, in der das Bisazid (b) mindestens eine Verbindung aus der nachstehenden Gruppe ist:

2,6-Di-(4'-azidbenzal)-4-methylcyclohexanon
4,4-Diazidchalcon,
2,6-Di-(4'-azidbenzal)-4-hydroxycyclohexan,
2,6-Di-(4'-azidbenzal)-4-methoxycyclohexanon,
2,6-Di-(4'-azidbenzal)-4-methylolcyclohexanon,
2,6-Di-(4'-azidbenzal)-4-trimethylsilylcyclohexanon
$\alpha_d$-Cyan-4,4'-diazidstilben und
2,6-Di-(4'-azidcinnamyliden)-4-hydroxycyclohexanon.

10. Zusammensetzung nach einem der vorhergehenden Ansprüche, in der das Amin (c) 3-(N,N-Dimethylamino)-propylmethacrylat, 4-(N,N-Dimethylamino)-butylmethacrylat oder 3-(N,N-Dimethylamino)-propylcinnamat ist.

11. Zusammensetzung nach Anspruch 10, in der das Amin (c) 4-(N,N-Dimethylamino)-butylmethacrylat oder 3-(N,N-Dimethylamino)-propylmethacrylat und das Bisazid (b) 2,6-Di-(4'-azid-benzal)-4-methylolcyclohexanon, 2,6-Di-(4'-Azidbenzal)-4-methoxycyclohexanon oder $\alpha_d$-Cyan-4,4'-Diazidstilben ist.

12. Verfahren zur Ausbildung eines Reliefmusters auf einem Substrat, bei dem das Substrat bildmäßig belichtet und das Bild entwickelt wird, dadurch gekennzeichnet, daß vor dem Belichten eine Zussammensetzung nach einem der Ansprüche 1 bis 11 auf das Substrat aufgetragen wird.

**Revendications**

1. Composition polymère photosensible comportant
(a) 100 parts en poids d'un acide de polyamide ou d'un polyamide présentant une substitution carboxyle,
(b) 0,1 à 100 parts en poids d'un bisazide,
(c) 1 à 400 parts en poids d'au moins une choisie dans le groupe incluant les amines contenant au moins une liaison non saturée dans chaque molécule.

2. Composition selon la revendication 1, qui comporte en outre (d) un photosensibilisateur.

3. Composition selon la revendication 1 ou 2, dans laquelle le bisazide (b) est au moins un élément choisi dans le groupe comprenant:

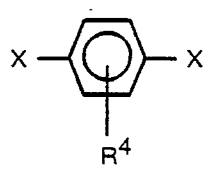
(4)

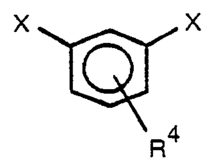
(5)

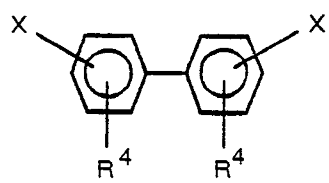
(6)

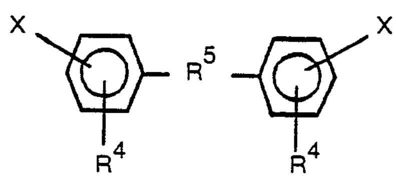
(7)

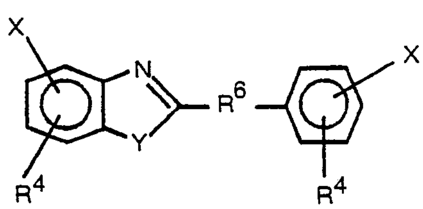
(8)

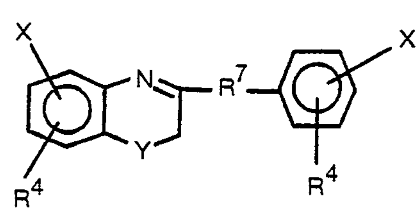
(9)

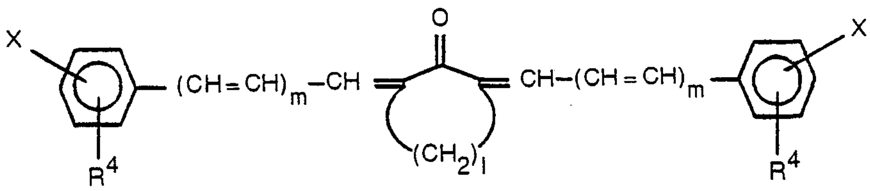

(10)

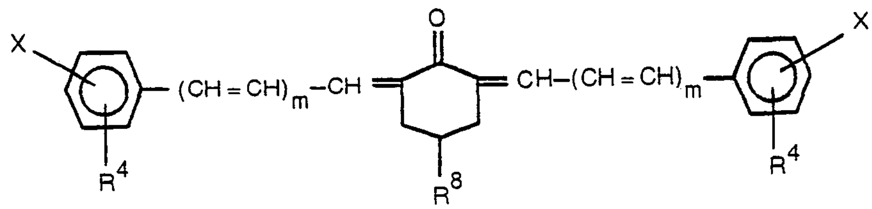

(11)

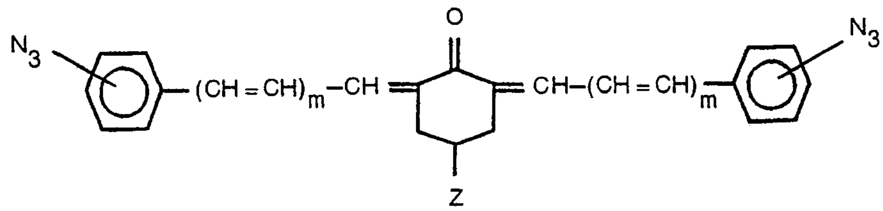

(12)

dans laquelle X est $-N_3$ ou $-SO_2N_3$; $R^4$ est de l'hydrogène, un groupe alcoyle $C_1-C_6$, du $-OH$, du $-OCH_3$, du $-COH$, du $-SO_3H$, du $-NO_2$ ou un halogène et chaque $R^4$ peut être identique ou différent; $R^5$, $R^6$ et $R^7$ sont, de façon indépendante, un groupe alkylène, $-SO_2-$, $-S-$, $-O-$,

$-SO_2-$, $-S-$, $-O-$,

$-NH-$, 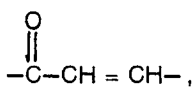, 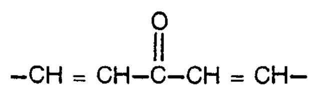, $-CH=CH-$, 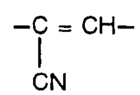,

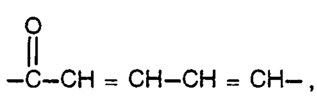, 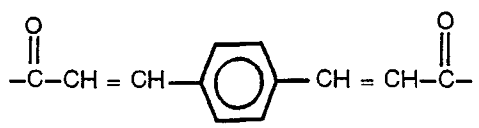,

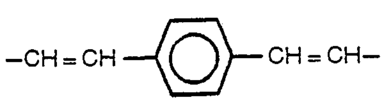, 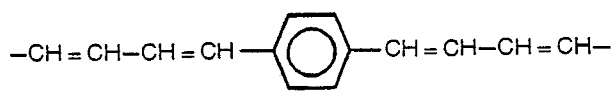,

$-CH=N-N=CH-$, $-CH=N-(CH_2)_k-N=CH-$, 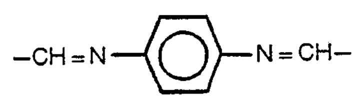,

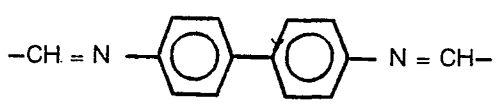, 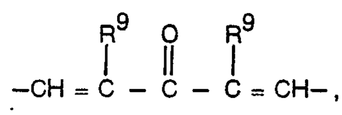,

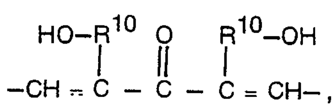, $-O-(CH_2)_k-O-$ ou 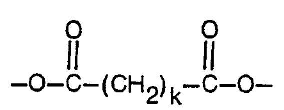;

$R^8$ is $-OH$, $-OR^9$, 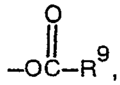, $-R^{10}-OH$, 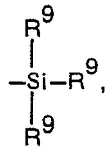, $-NH_2$, 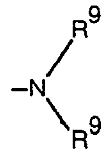,

$-COOH$, ou $-COOR^9$;

Y est —O—, —S— ou —NH—; l est un nombre entier compris entre 1 et 5; m est égal à zéro ou 1;

Z est $-OH$, $-OR^9$, $-R^{10}-OH$, 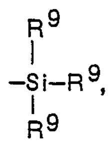, $-COOH$, $-COOR^9$, 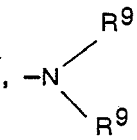 ou $-NH_2$;

$R^9$ est un groupe al-et $R^{10}$ est un groupe alkylène.

4. Composition selon la revendication 1, 2 ou 3, dans laquelle l'amine (c) est au moins un élément choisi dans le groupe incluant:

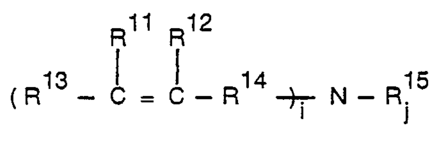 (13)

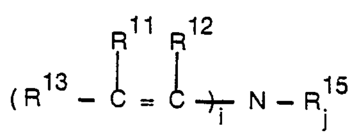 (14)

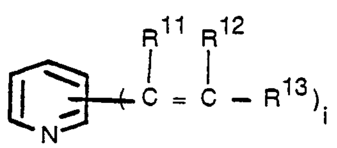 (15)

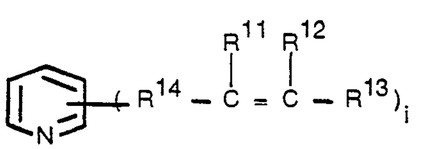 (16)

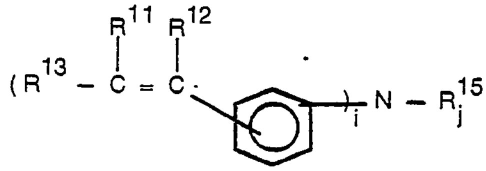 (17)

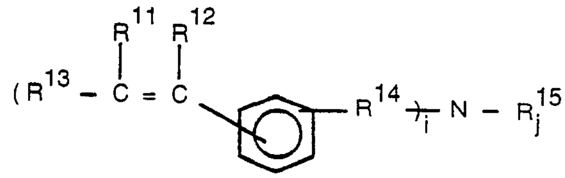

(19)

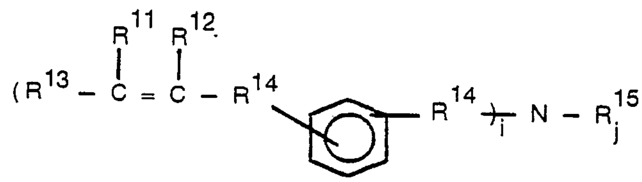

(20)

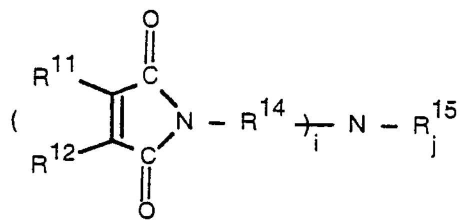

(21)

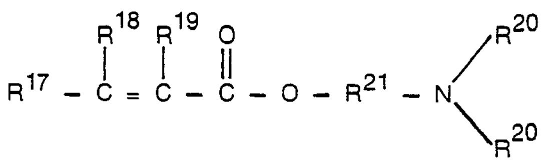

(22)

dans laquelle $R^{11}$, $R^{12}$, $R^{13}$ et $R^{15}$ sont, de façon indépendante, de l'hydrogène, un groupe alcoyle $C_1$—$C_6$, un groupe phényle, ou un groupe vinyle; $R^{14}$ est un groupe alkylène; i est un entier compris entre 1 et 3, i est zéro ou un nombre entier égal à 1 ou 2 et $i + j = 3$; $R^{17}$, $R^{18}$ et $R^{19}$ sont, de façon indépendante, de l'hydrogène, un groupe alcoyle $C_1$—$C_6$ ou un groupe vinyle; et $R^{20}$ est de l'hydrogène, un groupe alcoyle $C_1$—$C_6$ ou un groupe vinyle; et $R^{21}$ est un groupe alkylène.

5. Composition selon l'une quelconque des revendications précédentes, dans laquelle l'acide de polyamide ou le polyamide à substitution carboxyle (d) est un élément comportant comme composant principal une unité répétitive répondant à la formule:

$$-\!\!\left[ CO - \underset{\substack{| \\ (COOM)_n}}{R^1} - CONH - R^2 - NH \right]\!\!- \quad (1)$$

dans laquelle $R^1$ est un groupe organique trivalent ou tétravalent comportant 2 au moins atomes de carbone; $R^2$ est un groupe organique possédant au moins 2 atomes de carbone; M est de l'hydrogène, un métal alcalin ou un ion ammonium; et n est un nombre entier égal à 1 ou 2.

6. Composition selon l'une quelconque des revendications précédentes, dans lequel le bisazide (b) est

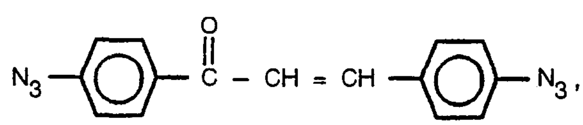

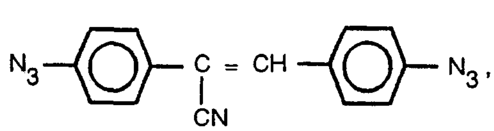 ou

un élément représenté par la formule

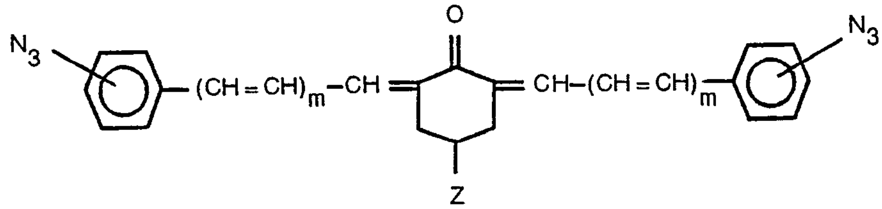

(12)

dans lequel Z est

du $-OH$, $-OR^9$, $-R^{10}-OH$, 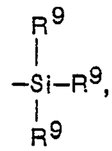, $-COOH$, $-COOR^9$, 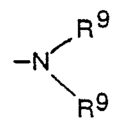 ou $-NH_2$;

$R^9$ est un groupe alcoyle $C_1$—$C_6$; $R^{10}$ est un groupe alkylène; et m est égal à zéro ou 1.

7. Composition selon l'une quelconque des revendications précédentes, dans laquelle l'amine (c) est un élément représenté par la formule:

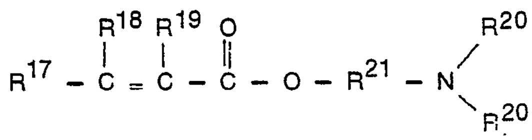

(24)

dans laquelle $R^{17}$, $R^{18}$ et $R^{19}$ sont, d'une manière indépendante, de l'hydrogène, un groupe alcoyle $C_1$—$C_6$, un groupe phényle ou un groupe vinyle; $R^{20}$ est de l'hydrogène, un groupe alcoyle $C_1$—$C_6$ ou un groupe vinyle; et $R^{21}$ est un groupe alkylène.

8. Composition selon l'une quelconque des revendications précédentes, dans laquelle l'acide de polyamide ou le polyamide à substitution carboxyle est un élément possédant comme composant principal une unité répétitive répondant à la formule:

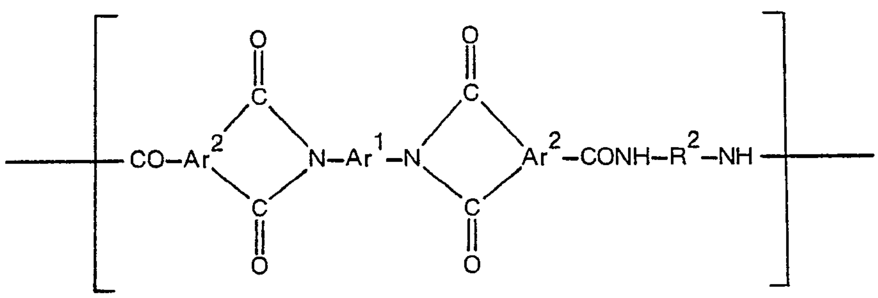

dans laquelle $R^2$ est un groupe contenant un noyau aromatique, un groupe contenant du silicium ou un groupe contenant un noyau hétérocyclique répondant à la formule:

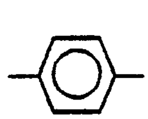 , 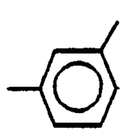 , 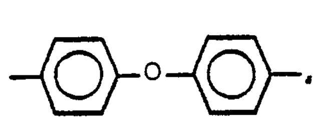 , 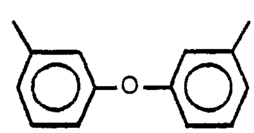 ,

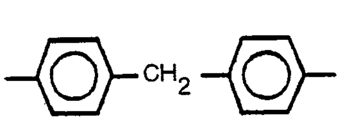 , 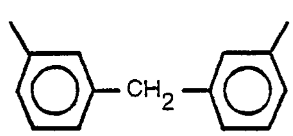 , 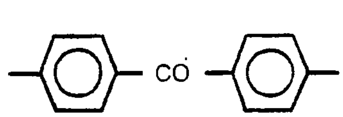 ,

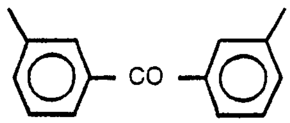 , 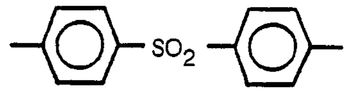 , 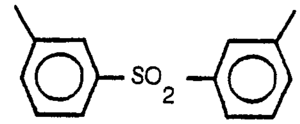 ,

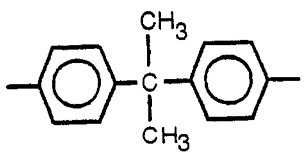 , 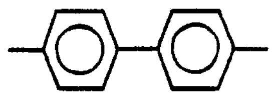 , 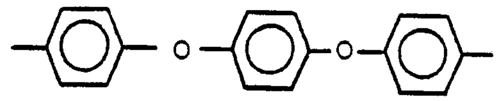 ,

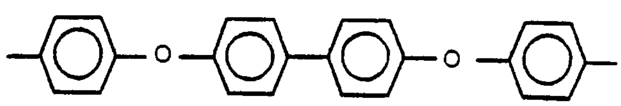 ,

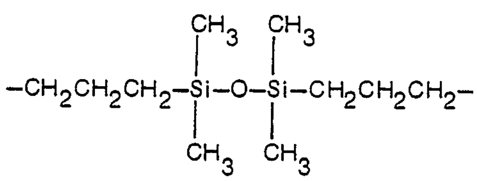 ,

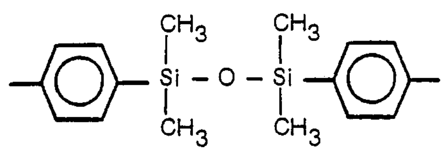 , ou 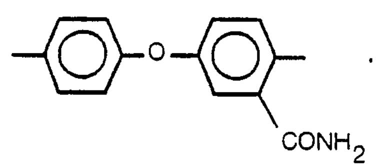 .

$Ar^1$ est un élément choisi dans le groupe incluant

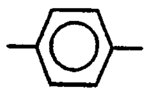 , 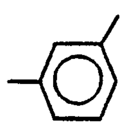 , 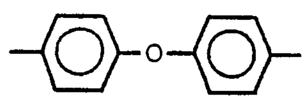 , 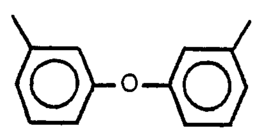 ,

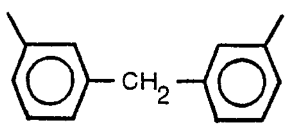 , 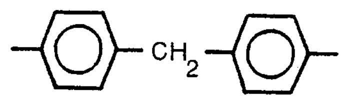 ,

et chaque $Ar^2$ est choisi, de faç on indépendante, dans le groupe incluant

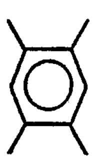 , 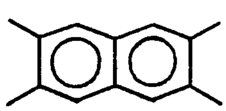 , 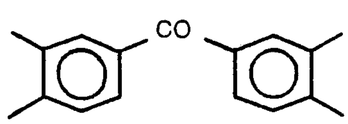 , 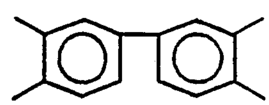 ,

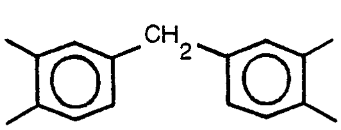 , 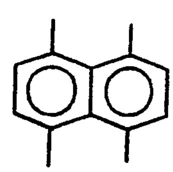 , et 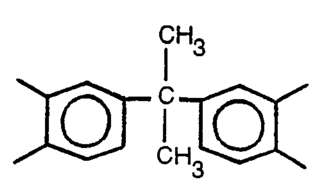 ,

dans laquelle les trois traits de liaison sont réunis aux trois groupes carbonyle de la chaîne principale du polymère et la l'autre trait de liaison est réuni à un groupe COOM, dans lequel M est tel que défini dans la revendication 5.

9. Composition selon l'une quelconque des revendications précédentes, dans laquelle le bisazide (b) est au moins un élément choisi dans le groupe incluant
2,6-di(4'-azidebenzal)-4-méthylcyclohexanone,
4,4-diazidechalcone,
2,6-di(4'-azidebenzal)-4-hydroxycyclohexane,
2,6-di(4'-azidebenzal)-4-méthoxycyclohexanone,
2,6-di(4'-azidebenzal)-4-methylolcyclohexanone,
2,6-di(4'-azidebenzal)-4-triméthylsilycyclohexanone,
$_d$-cyano-4,4'-diazidestilbène, et
2,6-di(4'-azidecinnamylidène)-4-hydroxycyclohexanone.

10. Composition selon l'une quelconque des revendications précédentes, dans laquelle l'amine (c) est du 3-(N,N-diméthylamino)propyl méthacylate, 4-(N,N-diméthylamino)butyl méthacrylate ou 3-(N,N-diméthylamino)propyl cinnamate.

11. Composition selon la revendication 10, dans laquelle l'amine (c) est du 4-(N,N-diméthylamino)butyi méthacrylate ou du 3-(N,N-diméthylamino)propyl méthacrylate et le bisazide (b) est de la 2,6-di(4'-azidebenzal)-4-méthylolcyclohexanone, de la 2,6-di-(4'-azidebenzal)-4-méthoxycyclohexanone, ou du $\alpha_d$-cyano-4,4'-diazidestilbène.

12. Procédé pour former un dessin en relief sur un substrat, consistant à exposer le substrat conformément à l'image, et à développer l'image, caractérisé par l'utilisation d'une composition telle que revendiquée dans l'une quelconque des revendications 1 à 11 sur le substrat, avant l'exposition.